# EUROPEAN PATENT APPLICATION

(11) **EP 4 510 472 A1**
(43) Date of publication of application: **19.02.2025**
(21) Application number: 23806789.6
(22) Date of filing: 10.05.2023
(51) Int. Cl.: H04B 10/69

(54) **OPTICAL COMMUNICATION METHOD AND RECEIVING-END APPARATUS**

(30) Priority: 19.05.2022 CN 202210547308
(71) Applicant: Huawei Technologies Co., Ltd., Shenzhen, Guangdong 518129 (CN)
(72) Inventor: WANG, Dong, Shenzhen, Guangdong 518129 (CN); LEI, Zhangwei, Shenzhen, Guangdong 518129 (CN)
(74) Representative: Goddar, Heinz J.
(86) International application number: PCT/CN2023/093304
(87) International publication number: WO 2023/221837

(57) **Abstract**

Embodiments of this application provide an optical communication method and a receive end apparatus, to accelerate, during transmit end switching or channel switching, a speed of outputting a stable signal by a TIA. The receive end apparatus includes a trans-impedance amplifier TIA, a control apparatus, and a first storage module. The control apparatus is configured to receive a signal transmit identity of a first signal, and determine, based on a correspondence that is between a signal transmit identity and a gain and that is stored in the first storage module, a first gain corresponding to the signal transmit identity of the first signal, where the signal transmit identity indicates a transmit end apparatus of a signal or a channel for receiving the signal. The TIA is configured to obtain the first gain from the control apparatus, and after receiving the first signal, amplify the first signal by using the first gain.

## Description

This application claims priority to Chinese Patent Application No. 202210547308.2, filed with the China National Intellectual Property Administration on May 19, 2022 and entitled "OPTICAL COMMUNICATION METHOD AND RECEIVE END APPARATUS", which is incorporated herein by reference in its entirety.

### TECHNICAL FIELD

This application relates to the field of communication technologies, and in particular, to an optical communication method and a receive end apparatus.

### BACKGROUND

At a receive end of an optical fiber communication system, a photodiode (photodiode, PD) is used to convert a received optical signal into an electrical signal. Because an electrical signal generated by the PD is weak, a trans-impedance amplifier (trans-impedance amplifier, TIA) usually needs to be connected to an output end of the PD to amplify the electrical signal generated by the PD.

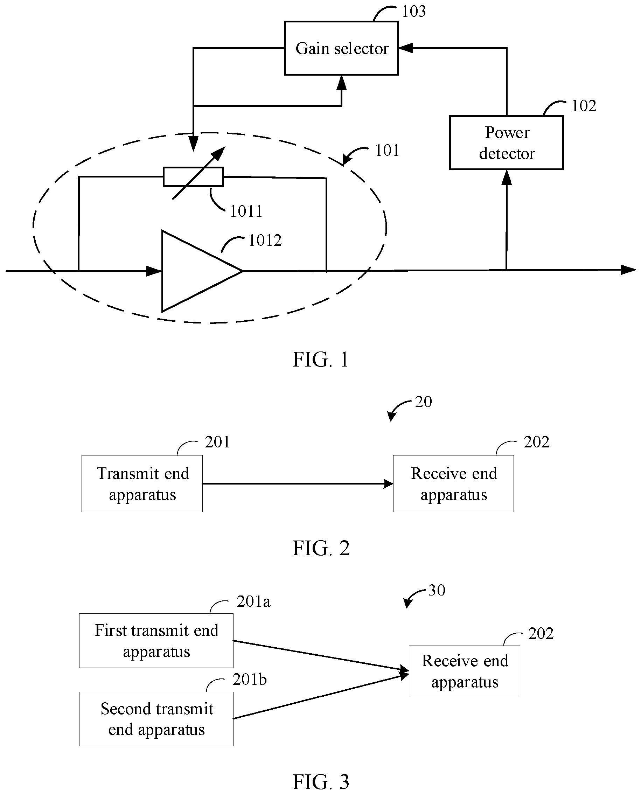

During actual application, especially during transmit end switching or channel switching, because the electrical signal generated by the PD, namely, an input signal of the TIA, changes, the TIA needs time to re-determine a gain for amplifying the input signal. On this basis, a conventional technology proposes a burst mode (burst mode) TIA structure shown in FIG. 1. As shown in FIG. 1, the burst-mode TIA structure includes a TIA 101, a power detector 102, and a gain selector 103. The TIA 101 includes a variable resistor 1011 and an amplifier 1012. The variable resistor 1011 is configured to adjust a gain of the amplifier 1012. The amplifier 1012 is configured to amplify the electrical signal generated by the PD. The power detector 102 is configured to determine an output power of the TIA 101 by detecting a voltage of an output signal of the amplifier 1012. The gain selector 103 is configured to determine, based on a power detection result output by the power detector 102, a gain for adjusting the amplifier 1012.

In the foregoing burst-mode TIA structure, it takes a long time to detect the power and select the gain based on the power detection result. This surely prolongs time for the TIA to determine the gain for amplifying the input signal. Further, if the TIA cannot quickly determine the gain for amplifying the input signal, the TIA delays outputting a stable signal.

Therefore, how to enable the TIA to quickly determine a gain, so as to quickly output a stable signal becomes an urgent technical problem to be resolved.

### SUMMARY

Embodiments of this application provide an optical communication method and a receive end apparatus, to accelerate, during transmit end switching or channel switching, a speed of outputting a stable signal by a TIA. To achieve the foregoing objective, the following technical solutions are used in embodiments of this application.

According to a first aspect, a receive end apparatus is provided. The receive end apparatus includes a trans-impedance amplifier TIA, a control apparatus, and a first storage module. The control apparatus is configured to receive a signal transmit identity of a first signal, and determine, based on a correspondence that is between a signal transmit identity and a gain and that is stored in the first storage module, a first gain corresponding to the signal transmit identity of the first signal, where the signal transmit identity indicates a transmit end apparatus of a signal or a channel for receiving the signal. The TIA is configured to obtain the first gain from the control apparatus, and after receiving the first signal, amplify the first signal by using the first gain.

In this embodiment of this application, because the first storage module stores the correspondence between the signal identity and the gain, the control apparatus may pre-determine the corresponding first gain based on the received signal transmit identity of the first signal. Therefore, after receiving the first signal, the TIA may directly amplify the first signal by using the first gain, and does not need to use the first signal to determine the first gain. Therefore, time required for determining the gain by the receive end apparatus can be shortened, and the receive end apparatus can quickly output a stable signal. That is, in this solution, duration from receiving a signal to outputting a stable signal by the receive end apparatus may be shortened.

With reference to the first aspect, in a possible implementation, the control apparatus is further configured to receive a signal transmit identity of a second signal, where the signal transmit identity of the second signal is the same as the signal transmit identity of the first signal. The TIA is further configured to: before receiving the first signal, receive the second signal, and amplify the second signal by using a second gain, where the second gain is a preset initial gain. The TIA is further configured to determine, based on strength of the amplified second signal, the first gain corresponding to the signal transmit identity of the first signal. The first storage module is configured to add a correspondence between the signal transmit identity of the first signal and the first gain to the correspondence between the signal transmit identity and the gain. In this solution, before receiving the first signal, the TIA pre-determines the first gain by using the second signal, where the second signal and the first signal have the same signal transmit identity. Therefore, after subsequently receiving the first signal, the TIA may directly amplify the first signal by using the first gain stored in the first storage module.

With reference to the first aspect, in a possible implementation, the TIA is further configured to determine, based on strength of the amplified first signal, a third gain corresponding to the signal transmit identity of the first signal. The first storage module is further configured to update the correspondence between the signal transmit identity of the first signal and the first gain to a correspondence between the signal transmit identity of the first signal and the third gain. In this solution, because a transmission condition, for example, a channel condition, may change with time, the TIA determines the third gain by using the first signal, and the first storage module updates the correspondence between the signal transmit identity and the gain, so that the updated correspondence between the signal transmit identity and the gain can better meet a current transmission condition.

With reference to the first aspect, in a possible implementation, the receive end apparatus further includes an automatic gain control AGC. The AGC is configured to determine, based on strength of the amplified first signal, a third gain corresponding to the signal transmit identity of the first signal. The first storage module is further configured to update the correspondence between the signal transmit identity of the first signal and the first gain to a correspondence between the signal transmit identity of the first signal and the third gain. In this solution, the AGC may determine the third gain by using the first signal, and the first storage module updates the correspondence between the signal transmit identity and the gain, so that the updated correspondence between the signal transmit identity and the gain can better meet a current transmission condition.

With reference to the first aspect, in a possible implementation, the receive end apparatus further includes an AGC, a processing module, and a second storage module coupled to the AGC. The AGC is configured to determine, based on strength of the amplified first signal, a third gain corresponding to the signal transmit identity of the first signal. The second storage module is configured to store a correspondence between the signal transmit identity of the first signal and the third gain. The processing module is configured to read the correspondence between the signal transmit identity of the first signal and the third gain from the second storage module, and update the correspondence between the signal transmit identity of the first signal and the first gain in the first storage module to the correspondence between the signal transmit identity of the first signal and the third gain. In this solution, the AGC may determine the third gain by using the first signal, and update, by using the second storage module and the processing module, the correspondence that is between the signal transmit identity and the gain and that is stored in the first storage module, so that the updated correspondence between the signal transmit identity and the gain can better meet a current transmission condition.

With reference to the first aspect, in a possible implementation, the receive end apparatus further includes an AGC. The control apparatus is further configured to receive a signal transmit identity of a second signal, where the signal transmit identity of the second signal is the same as the signal transmit identity of the first signal. The TIA is further configured to: before receiving the first signal, receive the second signal, and amplify the second signal by using a second gain, where the second gain is a preset initial gain. The AGC is configured to determine, based on strength of the amplified second signal, the first gain corresponding to the signal transmit identity of the first signal. The first storage module is configured to add a correspondence between the signal transmit identity of the first signal and the first gain to the correspondence between the signal transmit identity and the gain. In this solution, before receiving the first signal, the AGC pre-determines the first gain by using the second signal, where the second signal and the first signal have the same signal transmit identity. Therefore, after subsequently receiving the first signal, the TIA may directly amplify the first signal by using the first gain that is stored in the first storage module and that corresponds to the signal transmit identity of the first signal.

With reference to the first aspect, in a possible implementation, the AGC is further configured to determine, based on strength of the amplified first signal, a third gain corresponding to the signal transmit identity of the first signal. The first storage module is further configured to update the correspondence between the signal transmit identity of the first signal and the first gain to a correspondence between the signal transmit identity of the first signal and the third gain. In this solution, because a transmission condition, for example, a channel condition, may change with time, the AGC determines the third gain by using the first signal, and the first storage module updates the correspondence between the signal transmit identity and the gain, so that the updated correspondence between the signal transmit identity and the gain can better meet a current transmission condition.

With reference to the first aspect, in a possible implementation, the TIA is further configured to determine, based on strength of the amplified first signal, a third gain corresponding to the signal transmit identity of the first signal. The first storage module is further configured to update the correspondence between the signal transmit identity of the first signal and the first gain to a correspondence between the signal transmit identity of the first signal and the third gain. In this solution, because a transmission condition, for example, a channel condition, may change with time, the TIA determines the third gain by using the first signal, and the first storage module updates the correspondence between the signal transmit identity and the gain, so that the updated correspondence between the signal transmit identity and the gain can better meet a current transmission condition.

With reference to the first aspect, in a possible implementation, the receive end apparatus further includes an AGC, a processing module, and a second storage module coupled to the AGC. The control apparatus is further configured to receive a signal transmit identity of a second signal, where the signal transmit identity of the second signal is the same as the signal transmit identity of the first signal. The TIA is further configured to: before receiving the first signal, receive the second signal, and amplify the second signal by using a second gain, where the second gain is a preset initial gain. The AGC is configured to determine, based on strength of the amplified second signal, the first gain corresponding to the signal transmit identity of the first signal. The second storage module is configured to store a correspondence between the signal transmit identity of the first signal and the first gain. The processing module is configured to read the correspondence between the signal transmit identity of the first signal and the first gain from the second storage module, and add the correspondence between the signal transmit identity of the first signal and the first gain to the correspondence that is between the signal transmit identity and the gain and that is stored in the first storage module. In this solution, the AGC may pre-determine the first gain by using the second signal, and add the correspondence between the signal transmit identity of the first signal and the first gain to the first storage module by using the second storage module and the processing module, where the second signal and the first signal have the same signal transmit identity. Therefore, after subsequently receiving the first signal, the TIA may directly amplify the first signal by using the first gain stored in the first storage module.

With reference to the first aspect, in a possible implementation, the AGC is further configured to determine, based on strength of the amplified first signal, a third gain corresponding to a signal transmit end identity of the first signal. The second storage module is configured to store a correspondence between the signal transmit identity of the first signal and the third gain. The processing module is configured to read the correspondence between the signal transmit identity of the first signal and the third gain from the second storage module, and update the correspondence between the signal transmit identity of the first signal and the first gain in the first storage module to the correspondence between the signal transmit identity of the first signal and the third gain. In this solution, the AGC may determine the third gain by using the first signal, and update, by using the second storage module and the processing module, the correspondence that is between the signal transmit identity and the gain and that is stored in the first storage module, so that the updated correspondence between the signal transmit identity and the gain can better meet a current transmission condition.

With reference to the first aspect, in a possible implementation, the TIA is further configured to determine, based on strength of the amplified first signal, a third gain corresponding to the signal transmit identity of the first signal. The first storage module is further configured to update the correspondence between the signal transmit identity of the first signal and the first gain to a correspondence between the signal transmit identity of the first signal and the third gain. In this solution, because a transmission condition, for example, a channel condition, may change with time, the TIA determines the third gain by using the first signal, and the first storage module updates the correspondence between the signal transmit identity and the gain, so that the updated correspondence between the signal transmit identity and the gain can better meet a current transmission condition.

With reference to the first aspect, in a possible implementation, the receive end apparatus further includes a photodiode. The photodiode is configured to receive an optical signal, convert the optical signal into an electrical signal, and send the electrical signal to the TIA, where the electrical signal is the first signal or the second signal.

With reference to the first aspect, in a possible implementation, the control apparatus, the TIA, the first storage module, and the AGC are located on a first chip. This can save chip resources, including storage resources and computing resources.

With reference to the first aspect, in a possible implementation, the TIA and the first storage module are located on a first chip. The control apparatus, the AGC, the processing module, and the second storage module are located on a second chip. The chip on which the TIA and the first storage module are located is different from the chip on which the control apparatus, the AGC, the processing module, and the second storage module are located, so that design complexity of a single chip can be reduced, and chips produced by different manufacturers can be flexibly selected, so as to improve overall processing performance.

According to a second aspect, another receive end apparatus is provided. The receive end apparatus includes a trans-impedance amplifier TIA, a control apparatus, and a first storage module. The TIA is configured to receive a second signal and a third signal. The TIA is further configured to: if determining that an error between a power of the second signal and a power of the third signal is less than a first preset threshold, obtain a first gain from the first storage module by using the control apparatus, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal.

In this embodiment of this application, if determining that the error between the power of the second signal and the power of the third signal is less than the first preset threshold, after receiving the first signal, the TIA may directly amplify, by using the control apparatus, the first signal by using the first gain obtained from the first storage module, and does not need to use the first signal to determine the first gain. Therefore, time required for determining the gain by the receive end apparatus can be shortened, and the receive end apparatus can quickly output a stable signal. That is, in this solution, duration from receiving a signal to outputting a stable signal by the receive end apparatus may be shortened.

With reference to the second aspect, in a possible implementation, the TIA is further configured to: after receiving the second signal or the third signal, amplify the second signal or the third signal by using a second gain, where the second gain is a preset initial gain. The TIAis further configured to determine the first gain based on strength of the amplified second signal or strength of the amplified third signal. In this solution, before receiving the first signal, the TIA pre-determines the first gain by using the second signal or the third signal, where the error between the power of the second signal and the power of the third signal is less than the first preset threshold, and the second signal or the third signal and the first signal have the same signal transmit identity. Therefore, after subsequently receiving the first signal, the TIA may directly amplify the first signal by using the first gain stored in the first storage module.

With reference to the second aspect, in a possible implementation, the control apparatus is configured to receive the signal transmit identity of the first signal. The TIA is further configured to determine, based on strength of the amplified first signal, a third gain corresponding to the signal transmit identity of the first signal. The first storage module is further configured to store a correspondence between the signal transmit identity of the first signal and the third gain. In this solution, because a transmission condition, for example, a channel condition, may change with time, the TIA determines the third gain by using the first signal, and the first storage module stores the correspondence between the signal transmit identity of the first signal and the third gain, so that the gain stored in the first storage module can better meet a current transmission condition.

With reference to the second aspect, in a possible implementation, the receive end apparatus further includes an automatic gain control AGC. The control apparatus is configured to receive the signal transmit identity of the first signal. The AGC is configured to determine, based on strength of the amplified first signal, a third gain corresponding to the signal transmit identity of the first signal. The first storage module is further configured to store a correspondence between the signal transmit identity of the first signal and the third gain. In this solution, because a transmission condition, for example, a channel condition, may change with time, the AGC determines the third gain by using the first signal, and the first storage module stores the correspondence between the signal transmit identity of the first signal and the third gain, so that the gain stored in the first storage module can better meet a current transmission condition.

With reference to the second aspect, in a possible implementation, the receive end apparatus further includes an AGC, a processing module, and a second storage module coupled to the AGC. The control apparatus is configured to receive the signal transmit identity of the first signal. The AGC is configured to determine, based on strength of the amplified first signal, a third gain corresponding to the signal transmit identity of the first signal. The second storage module is configured to store a correspondence between the signal transmit identity of the first signal and the third gain. The processing module is configured to read the correspondence between the signal transmit identity of the first signal and the third gain from the second storage module, and write the correspondence between the signal transmit identity of the first signal and the third gain into the first storage module. In this solution, the AGC may determine the third gain by using the first signal, and write the correspondence between the signal transmit identity of the first signal and the third gain into the first storage module by using the second storage module and the processing module, so that the gain stored in the first storage module can better meet a current transmission condition.

With reference to the second aspect, in a possible implementation, the receive end apparatus further includes an AGC. The TIA is further configured to: after receiving the second signal or the third signal, amplify the second signal or the third signal by using a second gain, where the second gain is a preset initial gain. The AGC is configured to determine the first gain based on strength of the amplified second signal or strength of the amplified third signal. In this solution, before receiving the first signal, the AGC pre-determines the first gain by using the second signal or the third signal, where the error between the power of the second signal and the power of the third signal is less than the first preset threshold, and the second signal or the third signal and the first signal have the same signal transmit identity. Therefore, after subsequently receiving the first signal, the TIA may directly amplify the first signal by using the first gain stored in the first storage module.

With reference to the second aspect, in a possible implementation, the control apparatus is configured to receive the signal transmit identity of the first signal. The AGC is further configured to determine, based on strength of the amplified first signal, a third gain corresponding to the signal transmit identity of the first signal. The first storage module is further configured to store a correspondence between the signal transmit identity of the first signal and the third gain. In this solution, because a transmission condition, for example, a channel condition, may change with time, the AGC determines the third gain by using the first signal, and the first storage module stores the correspondence between the signal transmit identity of the first signal and the third gain, so that the gain stored in the first storage module can better meet a current transmission condition.

With reference to the second aspect, in a possible implementation, the control apparatus is configured to receive the signal transmit identity of the first signal. The TIA is further configured to determine, based on strength of the amplified first signal, a third gain corresponding to the signal transmit identity of the first signal. The first storage module is further configured to store a correspondence between the signal transmit identity of the first signal and the third gain. In this solution, because a transmission condition, for example, a channel condition, may change with time, the TIA determines the third gain by using the first signal, and the first storage module stores the correspondence between the signal transmit identity of the first signal and the third gain, so that the gain stored in the first storage module can better meet a current transmission condition.

With reference to the second aspect, in a possible implementation, the receive end apparatus further includes an AGC, a processing module, and a second storage module coupled to the AGC. The TIA is further configured to: after receiving the second signal or the third signal, amplify the second signal or the third signal by using a second gain, where the second gain is a preset initial gain. The AGC is further configured to determine the first gain based on strength of the amplified second signal or strength of the amplified third signal. The second storage module is configured to store the first gain determined by the AGC. The processing module is configured to read the first gain from the second storage module, and write the first gain into the first storage module. In this solution, before receiving the first signal, the AGC pre-determines the first gain by using the second signal or the third signal, where the error between the power of the second signal and the power of the third signal is less than the first preset threshold, the second signal or the third signal and the first signal have the same signal transmit identity, and the AGC writes the first gain into the first storage module by using the second storage module and the processing module. Therefore, after subsequently receiving the first signal, the TIA may directly amplify the first signal by using the first gain stored in the first storage module.

With reference to the second aspect, in a possible implementation, the control apparatus is configured to receive the signal transmit identity of the first signal. The AGC is further configured to determine, based on strength of the amplified first signal, a third gain corresponding to the signal transmit identity of the first signal. The second storage module is further configured to store a correspondence between the signal transmit identity of the first signal and the third gain. The processing module is configured to read the correspondence between the signal transmit identity of the first signal and the third gain from the second storage module, and write the correspondence between the signal transmit identity of the first signal and the third gain into the first storage module. In this solution, the AGC may determine the third gain by using the first signal, and write the correspondence between the signal transmit identity of the first signal and the third gain into the first storage module by using the second storage module and the processing module, so that the gain stored in the first storage module can better meet a current transmission condition.

With reference to the second aspect, in a possible implementation, the control apparatus is configured to receive the signal transmit identity of the first signal. The TIA is further configured to determine, based on strength of the amplified first signal, a third gain corresponding to the signal transmit identity of the first signal. The first storage module is further configured to store a correspondence between the signal transmit identity of the first signal and the third gain. In this solution, because a transmission condition, for example, a channel condition, may change with time, the TIA determines the third gain by using the first signal, and the first storage module stores the correspondence between the signal transmit identity of the first signal and the third gain, so that the gain stored in the first storage module can better meet a current transmission condition.

With reference to the second aspect, in a possible implementation, the receive end apparatus further includes a photodiode. The photodiode is configured to receive an optical signal, convert the optical signal into an electrical signal, and send the electrical signal to the TIA, where the electrical signal is the first signal, the second signal, or the third signal.

With reference to the second aspect, in a possible implementation, the control apparatus, the TIA, the first storage module, and the AGC are located on a first chip. This can save chip resources, including storage resources and computing resources.

With reference to the second aspect, in a possible implementation, the TIA and the first storage module are located on a first chip. The control apparatus, the AGC, the processing module, and the second storage module are located on a second chip. The chip on which the TIA and the first storage module are located is different from the chip on which the control apparatus, the AGC, the processing module, and the second storage module are located, so that design complexity of a single chip can be reduced, and chips produced by different manufacturers can be flexibly selected, so as to improve overall processing performance.

According to a third aspect, an optical communication method is provided. A communication apparatus that performs the optical communication method may be a receive end apparatus, or may be a module used in a receive end apparatus, for example, a chip or a chip system. The method includes: receiving a signal transmit identity of a first signal, and determining, based on a correspondence that is between a signal transmit identity and a gain and that is stored in a first storage module, a first gain corresponding to the signal transmit identity of the first signal, where the signal transmit identity indicates a transmit end apparatus of a signal or a channel for receiving the signal; and obtaining the first gain from a control apparatus, and after receiving the first signal, amplifying the first signal by using the first gain.

For technical effects brought by the third aspect, refer to technical effects brought by the first aspect. Details are not described herein again.

According to a fourth aspect, an optical communication method is provided. A communication apparatus that performs the optical communication method may be a receive end apparatus, or may be a module used in a receive end apparatus, for example, a chip or a chip system. The method includes: receiving a second signal and a third signal; and if determining that an error between a power of the second signal and a power of the third signal is less than a first preset threshold, obtaining a first gain from a first storage module by using a control apparatus, and after receiving a first signal, amplifying the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal.

For technical effects brought by the fourth aspect, refer to technical effects brought by the second aspect. Details are not described herein again.

According to a fifth aspect, a receive end apparatus is provided, including a processor. The processor is configured to be coupled to a memory, read computer instructions stored in the memory, and then perform the method according to the third aspect or the fourth aspect based on the instructions.

With reference to the fifth aspect, in a possible implementation, the receive end apparatus further includes the memory. The memory is configured to store the computer instructions.

With reference to the fifth aspect, in a possible implementation, the receive end apparatus further includes a communication interface. The communication interface is used by the receive end apparatus to communicate with another device. For example, the communication interface may be a transceiver, an input/output interface, an interface circuit, an output circuit, an input circuit, a pin, a related circuit, or the like.

With reference to the fifth aspect, in a possible implementation, the receive end apparatus may be a chip or a chip system. When the receive end apparatus is a chip system, the receive end apparatus may include a chip, or may include a chip and another discrete device.

With reference to the fifth aspect, in a possible implementation, when the receive end apparatus is a chip or a chip system, the communication interface may be an input/output interface, an interface circuit, an output circuit, an input circuit, a pin, a related circuit, or the like on the chip or the chip system. The processor may alternatively be implemented as a processing circuit or a logic circuit.

According to a sixth aspect, a communication system is provided. The communication system includes a transmit end apparatus and the receive end apparatus according to the first aspect, the communication system includes a transmit end apparatus and the receive end apparatus according to the second aspect, or the communication system includes a first transmit end apparatus, a second transmit end apparatus, and the receive end apparatus according to the second aspect.

According to a seventh aspect, a computer-readable storage medium is provided. The computer-readable storage medium stores instructions. When the instructions are run on a computer, the computer is enabled to perform the method according to the third aspect or the fourth aspect.

According to an eighth aspect, a computer program product including instructions is provided. When the computer program product runs on a computer, the computer is enabled to perform the method according to the third aspect or the fourth aspect.

For technical effects brought by any design manner of the fifth aspect to the eighth aspect, refer to technical effects brought by different design manners of the first aspect or the second aspect. Details are not described herein again.

### BRIEF DESCRIPTION OF DRAWINGS

FIG. 1 is a diagram of a burst-mode TIA structure in a conventional technology;
FIG. 2 is a diagram of an architecture of a communication system according to an embodiment of this application;
FIG. 3 is a diagram of an architecture of another communication system according to an embodiment of this application;
FIG. 4 is a diagram of an architecture of still another communication system according to an embodiment of this application;
FIG. 5 is a diagram of a structure of a receive end apparatus according to an embodiment of this application;
FIG. 6 is a diagram of another structure of a receive end apparatus according to an embodiment of this application;
FIG. 7 is a diagram of still another structure of a receive end apparatus according to an embodiment of this application;
FIG. 8 is a diagram of a structure of a transmit end apparatus according to an embodiment of this application;
FIG. 9 is a specific diagram of still another structure of a receive end apparatus according to an embodiment of this application;
FIG. 10 is a diagram of a structure of a communication apparatus according to an embodiment of this application;
FIG. 11 is a flowchart of an example 1 of an optical communication method according to this application;
FIG. 12 is a flowchart of an example 2 of an optical communication method according to this application;
FIG. 13 is a flowchart of an example 3 of an optical communication method according to this application;
FIG. 14 is a flowchart of an example 4 of an optical communication method according to this application;
FIG. 15 is a flowchart of an example 1 of another optical communication method according to this application;
FIG. 16 is a flowchart of an example 2 of another optical communication method according to this application;
FIG. 17 is a flowchart of an example 3 of another optical communication method according to this application; and
FIG. 18 is a flowchart of an example 4 of another optical communication method according to this application.

### DESCRIPTION OF EMBODIMENTS

As described in the background, in scenarios such as an optical switching network or a passive optical network (passive optical network, PON), during transmit end switching, channel switching, or optical fiber fault correction, a receive end is expected to quickly output a stable signal. In a burst-mode TIA structure used in a conventional technology, in a scenario in which a single-wavelength rate is greater than or equal to 50 Gbps, duration from receiving a signal to outputting a stable signal by a receive end is long.

The following describes the technical solutions in embodiments of this application with reference to the accompanying drawings in embodiments of this application. In descriptions of this application, unless otherwise specified, "/" represents an "or" relationship between associated objects. For example, A/B may represent A or B. In this application, "and/or" describes only an association relationship for describing associated objects and represents that three relationships may exist. For example, A and/or B may represent the following three cases: Only A exists, both A and B exist, and only B exists, where A or B may be singular or plural. In addition, in the descriptions of this application, "a plurality of" means two or more than two unless otherwise specified. "At least one of the following items (pieces)" or a similar expression thereof means any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, in embodiments of this application, words such as "first" and "second" are used for distinguishing between same items or similar items that have basically same functions or purposes. A person skilled in the art may understand that the words such as "first" and "second" do not limit a quantity or an execution sequence, and the words such as "first" and "second" do not indicate a definite difference.

FIG. 2 shows a communication system 20 according to an embodiment of this application. The communication system 20 includes a transmit end apparatus 201 and a receive end apparatus 202. The receive end apparatus 202 is configured to receive a signal transmit identity of a first signal, and determine, based on a stored correspondence between a signal transmit identity and a gain, a first gain corresponding to the signal transmit identity of the first signal, where the signal transmit identity indicates a transmit end apparatus of a signal or a channel for receiving the signal. The transmit end apparatus 201 is configured to send the first signal to the receive end apparatus 202; or the transmit end apparatus 201 is configured to send the first signal to the receive end apparatus 202 on a first channel. The receive end apparatus 202 is further configured to: after receiving the first signal, amplify the first signal by using the first gain. Specific implementation and technical effects of the solution are described in detail in subsequent apparatus embodiments. Details are not described herein again.

FIG. 3 shows another communication system 30 according to an embodiment of this application. The communication system 30 includes a first transmit end apparatus 201a, a second transmit end apparatus 201b, and a receive end apparatus 202. The first transmit end apparatus 201a is configured to send a second signal to the receive end apparatus 202. The receive end apparatus 202 is configured to receive the second signal. The second transmit end apparatus 201b is configured to send a third signal to the receive end apparatus 202. The receive end apparatus 202 is further configured to receive the third signal. The first transmit end apparatus 201a is further configured to send the first signal to the receive end apparatus 202, that is, a signal transmit identity of the first signal is the same as a signal transmit identity of the second signal; or the second transmit end apparatus 201b is further configured to send the first signal to the receive end apparatus 202, that is, a signal transmit identity of the first signal is the same as a signal transmit identity of the third signal. The signal transmit identity indicates a transmit end apparatus of a signal or a channel for receiving the signal. The receive end apparatus 202 is further configured to: if determining that an error between a power of the second signal and a power of the third signal is less than a first preset threshold, after receiving the first signal, amplify the first signal by using a stored first gain. Specific implementation and technical effects of the solution are described in detail in subsequent apparatus embodiments. Details are not described herein again.

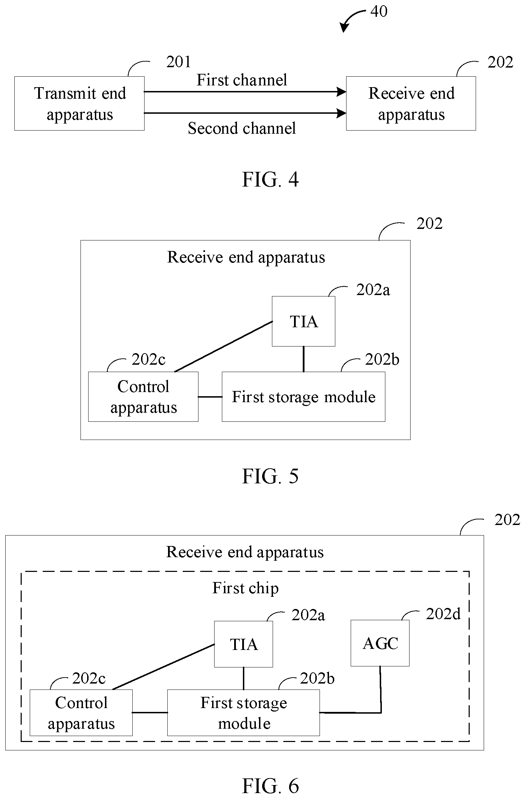

FIG. 4 shows still another communication system 40 according to an embodiment of this application. The communication system 40 includes a transmit end apparatus 201 and a receive end apparatus 202. The transmit end apparatus 201 is configured to send a second signal to the receive end apparatus 202 on a first channel. The receive end apparatus 202 is configured to receive a second signal on the first channel. The transmit end apparatus 201 is further configured to send a third signal to the receive end apparatus 202 on a second channel. The receive end apparatus 202 is further configured to receive the third signal on the second channel. The transmit end apparatus 201 is further configured to send the first signal to the receive end apparatus 202 on the first channel, that is, a signal transmit identity of the first signal is the same as a signal transmit identity of the second signal; or the transmit end apparatus 201 is further configured to send the first signal to the receive end apparatus 202 on the second channel, that is, a signal transmit identity of the first signal is the same as a signal transmit identity of the third signal. The signal transmit identity indicates a channel for receiving a signal. The receive end apparatus 202 is further configured to: if determining that an error between a power of the second signal and a power of the third signal is less than a first preset threshold, after receiving the first signal, amplify the first signal by using a stored first gain. Specific implementation and technical effects of the solution are described in detail in subsequent apparatus embodiments. Details are not described herein again.

Correspondingly, an embodiment of this application further provides a receive end apparatus. The receive end apparatus is configured to implement the foregoing functions. It may be understood that, to implement the foregoing functions, the receive end apparatus includes a hardware structure and/or a software module for performing a corresponding function. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. Different methods may be used to implement the described functions for each particular application, but it should not be considered that the implementation goes beyond the scope of this application.

In embodiments of this application, the receive end apparatus may be divided into functional modules based on the foregoing system embodiments. For example, each functional module may be obtained through division based on each corresponding function, or two or more functions may be integrated into one processing module. The integrated module may be implemented in a form of hardware, or may be implemented in a form of a software functional module. It should be noted that, in embodiments of this application, module division is an example, and is merely a logical function division. During actual implementation, another division manner may be used.

FIG. 5 shows a structure of the receive end apparatus 202 according to an embodiment of this application. The receive end apparatus 202 includes a TIA202a, a first storage module 202b, and a control apparatus 202c.

With reference to FIG. 2, the control apparatus 202c is configured to receive the signal transmit identity of the first signal, and determine, based on the correspondence that is between the signal transmit identity and the gain and that is stored in the first storage module 202b, the first gain corresponding to the signal transmit identity of the first signal, where the signal transmit identity indicates a transmit end apparatus of a signal or a channel for receiving the signal. The TIA 202a is configured to obtain the first gain from the control apparatus 202c, and after receiving the first signal, amplify the first signal by using the first gain. Because the first storage module 202b pre-stores the correspondence between the signal transmit identity and the gain, the control apparatus 202c may pre-determine the corresponding first gain based on the received signal transmit identity of the first signal. Therefore, after receiving the first signal, the TIA 202a may directly amplify the first signal by using the first gain, and does not need to use the first signal to determine the first gain. Therefore, time required for determining the gain by the receive end apparatus 202 can be shortened, and the receive end apparatus 202 can quickly output a stable signal. That is, in this solution, duration from receiving a signal to outputting a stable signal by the receive end apparatus 202 may be shortened.

In this embodiment of this application, the TIA 202a may have an AGC mode and a manual gain control (manual gain control, MGC) mode. In the foregoing use, the TIA 202a is in an MGC mode, that is, obtains the gain from the outside, and amplifies the signal by using the gain obtained from the outside.

It should be noted that the foregoing functions of the control apparatus 202c may alternatively be implemented by the TIA 202a. This is not limited in embodiments of this application.

It should be noted that the identity (identity, ID) in this embodiment of this application may also be referred to as an index number, and is used to uniquely identify sending of a signal. This is not limited in embodiments of this application.

In this embodiment of this application, a scheduling apparatus may be configured to perform overall scheduling on the transmit end apparatus and the receive end apparatus. Specifically, the scheduling apparatus may be configured to determine which transmit end apparatus sends a signal and which receive end apparatus receives a signal. Optionally, the scheduling apparatus may be further configured to determine which channel is used to communicate a signal. It should be noted that all channels may be identified, that is, one channel identity may uniquely identify one channel, and the signal transmit identity may be a channel identity; or one or more channels of each transmit end apparatus may be identified, that is, one transmit end apparatus identity and one channel identity may uniquely identify one channel, and the signal transmit identity may be a transmit end identity and a channel identity. In addition, the scheduling apparatus may send a control signal to the determined transmit end apparatus or receive end apparatus, to control execution of scheduling. For example, assuming that the scheduling apparatus determines that a transmit end apparatus 1 sends a signal and a receive end apparatus 2 receives the signal, the scheduling apparatus may send a control signal including an identity of the receive end apparatus 2 to the transmit end apparatus 1, and send a control signal including an identity of the transmit end apparatus 1 to the receive end apparatus 2, so as to control the transmit end apparatus 1 to send a signal to the receive end apparatus 2. For another example, assuming that the scheduling apparatus determines that a transmit end apparatus 1 sends a signal on a channel 3, and a receive end apparatus 2 receives the signal, if an identity of the channel 3 may uniquely identify the channel 3, the scheduling apparatus may send a control signal including the identity of the channel 3 to the transmit end apparatus 1, and send a control signal including the identity of the channel 3 to the receive end apparatus 2, so as to control the transmit end apparatus 1 to send a signal to the receive end apparatus 2 on the channel 3; or if an identity of the transmit end apparatus 1 and an identity of the channel 3 may uniquely identify a channel, the scheduling apparatus may send a control signal including the identity of the transmit end apparatus 1 and the identity of the channel 3 to the transmit end apparatus 1, and send a control signal including the identity of the transmit end apparatus 1 and the identity of the channel 3 to the receive end apparatus 2, so as to control the transmit end apparatus 1 to send a signal to the receive end apparatus 2 on the channel 3.

For example, the signal transmit identity may be carried in the control signal sent by the scheduling apparatus to the receive end apparatus 202.

Optionally, the control apparatus 202c is further configured to receive a signal transmit identity of a second signal, where the signal transmit identity of the second signal is the same as the signal transmit identity of the first signal. The TIA 202a is further configured to: before receiving the first signal, receive the second signal, and amplify the second signal by using a second gain, where the second gain is a preset initial gain. The TIA 202a is further configured to determine, based on strength of the amplified second signal, the first gain corresponding to the signal transmit identity of the first signal. The first storage module 202b is configured to add a correspondence between the signal transmit identity of the first signal and the first gain to the correspondence between the signal transmit identity and the gain. In this solution, before receiving the first signal, the TIA 202a pre-determines the first gain by using the second signal, where the second signal and the first signal have the same signal transmit identity. Therefore, after subsequently receiving the first signal, the TIA 202a may directly amplify the first signal by using the first gain stored in the first storage module 202b.

Optionally, the TIA 202a is further configured to determine, based on strength of the amplified first signal, a third gain corresponding to the signal transmit identity of the first signal. The first storage module 202b is further configured to update the correspondence between the signal transmit identity of the first signal and the first gain to a correspondence between the signal transmit identity of the first signal and the third gain. In this solution, because a transmission condition, for example, a channel condition, may change with time, the TIA 202a determines the third gain by using the first signal, and the first storage module 202b updates the correspondence between the signal transmit identity and the gain, so that the updated correspondence between the signal transmit identity and the gain can better meet a current transmission condition.

In this embodiment of this application, when the TIA 202a determines the first gain by using the second signal, or when the TIA 202a determines the third gain by using the first signal, the TIA 202a is in an AGC mode. This is uniformly described herein, and details are not described below.

FIG. 6 shows another structure of the receive end apparatus 202 according to an embodiment of this application. The receive end apparatus 202 includes a TIA 202a, a first storage module 202b, a control apparatus 202c, and an AGC 202d. Optionally, the TIA 202a, the first storage module 202b, the control apparatus 202c, and the AGC 202d are located on a same chip, namely, a first chip. This can save chip resources, including storage resources and computing resources.

With reference to FIG. 2, the control apparatus 202c is configured to receive the signal transmit identity of the first signal, and determine, based on the correspondence that is between the signal transmit identity and the gain and that is stored in the first storage module 202b, the first gain corresponding to the signal transmit identity of the first signal, where the signal transmit identity indicates a transmit end apparatus of a signal or a channel for receiving the signal. The TIA 202a is configured to obtain the first gain from the control apparatus 202c, and after receiving the first signal, amplify the first signal by using the first gain. For related descriptions of the solution, refer to the embodiment shown in FIG. 5. Details are not described herein again.

Optionally, the control apparatus 202c is further configured to receive a signal transmit identity of a second signal, where the signal transmit identity of the second signal is the same as the signal transmit identity of the first signal. The TIA 202a is further configured to: before receiving the first signal, receive the second signal, and amplify the second signal by using a second gain, where the second gain is a preset initial gain. The TIA 202a is further configured to determine, based on strength of the amplified second signal, the first gain corresponding to the signal transmit identity of the first signal. The first storage module 202b is configured to add a correspondence between the signal transmit identity of the first signal and the first gain to the correspondence between the signal transmit identity and the gain. For related descriptions of the solution, refer to the embodiment shown in FIG. 5. Details are not described herein again.

Optionally, the AGC 202d is configured to determine, based on strength of the amplified first signal, a third gain corresponding to the signal transmit identity of the first signal. The first storage module 202b is further configured to update the correspondence between the signal transmit identity of the first signal and the first gain to a correspondence between the signal transmit identity of the first signal and the third gain. In this solution, the AGC 202d may determine the third gain by using the first signal, and the first storage module 202b updates the correspondence between the signal transmit identity and the gain, so that the updated correspondence between the signal transmit identity and the gain can better meet a current transmission condition.

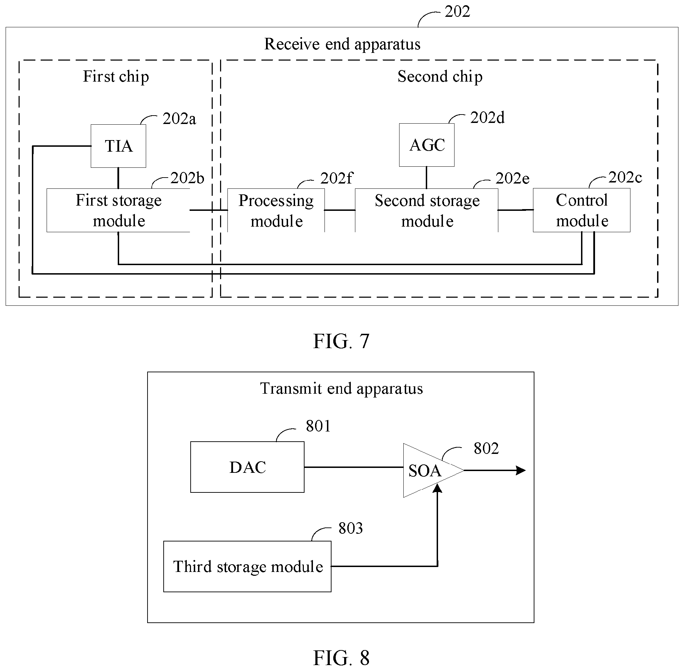

FIG. 7 shows still another structure of the receive end apparatus 202 according to an embodiment of this application. The receive end apparatus 202 includes a TIA 202a and a first storage module 202b that are located on a first chip, and a control apparatus 202c, an AGC 202d, a processing module 202f, and a second storage module 202e that are located on a second chip. The chip on which the TIA 202a and the first storage module 202b are located is different from the chip on which the control apparatus 202c, the AGC 202d, the processing module 202f, and the second storage module 202e are located, so that design complexity of a single chip can be reduced, and chips produced by different manufacturers can be flexibly selected, so as to improve overall processing performance.

With reference to FIG. 2, the control apparatus 202c is configured to receive the signal transmit identity of the first signal, and determine, based on the correspondence that is between the signal transmit identity and the gain and that is stored in the first storage module 202b, the first gain corresponding to the signal transmit identity of the first signal, where the signal transmit identity indicates a transmit end apparatus of a signal or a channel for receiving the signal. The TIA 202a is configured to obtain the first gain from the control apparatus 202c, and after receiving the first signal, amplify the first signal by using the first gain. For related descriptions of the solution, refer to the embodiment shown in FIG. 5. Details are not described herein again.

Optionally, the control apparatus 202c is further configured to receive a signal transmit identity of a second signal, where the signal transmit identity of the second signal is the same as the signal transmit identity of the first signal. The TIA 202a is further configured to: before receiving the first signal, receive the second signal, and amplify the second signal by using a second gain, where the second gain is a preset initial gain. The TIA 202a is further configured to determine, based on strength of the amplified second signal, the first gain corresponding to the signal transmit identity of the first signal. The first storage module 202b is configured to add a correspondence between the signal transmit identity of the first signal and the first gain to the correspondence between the signal transmit identity and the gain. For related descriptions of the solution, refer to the embodiment shown in FIG. 5. Details are not described herein again.

Optionally, the AGC 202d is configured to determine, based on strength of the amplified first signal, a third gain corresponding to the signal transmit identity of the first signal. The second storage module 202e is configured to store a correspondence between the signal transmit identity of the first signal and the third gain. The processing module 202f is configured to read the correspondence between the signal transmit identity of the first signal and the third gain from the second storage module 202e, and update the correspondence between the signal transmit identity of the first signal and the first gain in the first storage module 202b to the correspondence between the signal transmit identity of the first signal and the third gain. In this solution, the AGC 202d may determine the third gain by using the first signal, and update, by using the second storage module 202e and the processing module 202f, the correspondence that is between the signal transmit identity and the gain and that is stored in the first storage module 202b, so that the updated correspondence between the signal transmit identity and the gain can better meet a current transmission condition.

In this embodiment of this application, the processing module 202f may be configured to migrate data between the first storage module 202b and the second storage module 202e. For example, the processing module 202f may be a microcontroller unit (microcontroller unit, MCU).

With reference to FIG. 2 and FIG. 6, the control apparatus 202c is configured to receive the signal transmit identity of the first signal, and determine, based on the correspondence that is between the signal transmit identity and the gain and that is stored in the first storage module 202b, the first gain corresponding to the signal transmit identity of the first signal, where the signal transmit identity indicates a transmit end apparatus of a signal or a channel for receiving the signal. The TIA 202a is configured to obtain the first gain from the control apparatus 202c, and after receiving the first signal, amplify the first signal by using the first gain. For related descriptions of the solution, refer to the embodiment shown in FIG. 5. Details are not described herein again.

Optionally, the control apparatus 202c is further configured to receive a signal transmit identity of a second signal, where the signal transmit identity of the second signal is the same as the signal transmit identity of the first signal. The TIA 202a is further configured to: before receiving the first signal, receive the second signal, and amplify the second signal by using a second gain, where the second gain is a preset initial gain. The AGC 202d is configured to determine, based on strength of the amplified second signal, the first gain corresponding to the signal transmit identity of the first signal. The first storage module 202b is configured to add a correspondence between the signal transmit identity of the first signal and the first gain to the correspondence between the signal transmit identity and the gain. In this solution, before receiving the first signal, the AGC 202d pre-determines the first gain by using the second signal, where the second signal and the first signal have the same signal transmit identity. Therefore, after subsequently receiving the first signal, the TIA 202a may directly amplify the first signal by using the first gain that is stored in the first storage module 202b and that corresponds to the signal transmit identity of the first signal.

In a possible implementation, the AGC 202d is further configured to determine, based on strength of the amplified first signal, a third gain corresponding to the signal transmit identity of the first signal. The first storage module 202b is further configured to update the correspondence between the signal transmit identity of the first signal and the first gain to a correspondence between the signal transmit identity of the first signal and the third gain. In this solution, because a transmission condition, for example, a channel condition, may change with time, the AGC 202d determines the third gain by using the first signal, and the first storage module 202b updates the correspondence between the signal transmit identity and the gain, so that the updated correspondence between the signal transmit identity and the gain can better meet a current transmission condition.

In another possible implementation, the TIA 202a is further configured to determine, based on strength of the amplified first signal, a third gain corresponding to the signal transmit identity of the first signal. The first storage module 202b is further configured to update the correspondence between the signal transmit identity of the first signal and the first gain to a correspondence between the signal transmit identity of the first signal and the third gain. In this solution, because a transmission condition, for example, a channel condition, may change with time, the TIA 202a determines the third gain by using the first signal, and the first storage module 202b updates the correspondence between the signal transmit identity and the gain, so that the updated correspondence between the signal transmit identity and the gain can better meet a current transmission condition.

With reference to FIG. 2 and FIG. 7, the control apparatus 202c is configured to receive the signal transmit identity of the first signal, and determine, based on the correspondence that is between the signal transmit identity and the gain and that is stored in the first storage module 202b, the first gain corresponding to the signal transmit identity of the first signal, where the signal transmit identity indicates a transmit end apparatus of a signal or a channel for receiving the signal. The TIA 202a is configured to obtain the first gain from the control apparatus 202c, and after receiving the first signal, amplify the first signal by using the first gain. For related descriptions of the solution, refer to the embodiment shown in FIG. 5. Details are not described herein again.

Optionally, the control apparatus 202c is further configured to receive a signal transmit identity of a second signal, where the signal transmit identity of the second signal is the same as the signal transmit identity of the first signal. The TIA 202a is further configured to: before receiving the first signal, receive the second signal, and amplify the second signal by using a second gain, where the second gain is a preset initial gain. The AGC 202d is configured to determine, based on strength of the amplified second signal, the first gain corresponding to the signal transmit identity of the first signal. The second storage module 202e is configured to store a correspondence between the signal transmit identity of the first signal and the first gain. The processing module 202f is configured to read the correspondence between the signal transmit identity of the first signal and the first gain from the second storage module 202e, and add the correspondence between the signal transmit identity of the first signal and the first gain to the correspondence that is between the signal transmit identity and the gain and that is stored in the first storage module 202b. In this solution, the AGC 202d may pre-determine the first gain by using the second signal, and add the correspondence between the signal transmit identity of the first signal and the first gain to the first storage module 202b by using the second storage module 202e and the processing module 202f, where the second signal and the first signal have the same signal transmit identity. Therefore, after subsequently receiving the first signal, the TIA 202a may directly amplify the first signal by using the first gain stored in the first storage module 202b.

In a possible implementation, the AGC 202d is further configured to determine, based on strength of the amplified first signal, a third gain corresponding to a signal transmit end identity of the first signal. The second storage module 202e is configured to store a correspondence between the signal transmit identity of the first signal and the third gain. The processing module 202f is configured to read the correspondence between the signal transmit identity of the first signal and the third gain from the second storage module 202e, and update the correspondence between the signal transmit identity of the first signal and the first gain in the first storage module 202b to the correspondence between the signal transmit identity of the first signal and the third gain. In this solution, the AGC 202d may determine the third gain by using the first signal, and update, by using the second storage module 202e and the processing module 202f, the correspondence that is between the signal transmit identity and the gain and that is stored in the first storage module 202b, so that the updated correspondence between the signal transmit identity and the gain can better meet a current transmission condition.

In another possible implementation, the TIA 202a is further configured to determine, based on strength of the amplified first signal, a third gain corresponding to the signal transmit identity of the first signal. The first storage module 202b is further configured to update the correspondence between the signal transmit identity of the first signal and the first gain to a correspondence between the signal transmit identity of the first signal and the third gain. In this solution, because a transmission condition, for example, a channel condition, may change with time, the TIA 202a determines the third gain by using the first signal, and the first storage module 202b updates the correspondence between the signal transmit identity and the gain, so that the updated correspondence between the signal transmit identity and the gain can better meet a current transmission condition.

Optionally, the receive end apparatus 202 shown in FIG. 5 to FIG. 7 may further include a photodiode. The photodiode is configured to receive an optical signal, convert the optical signal into an electrical signal, and send the electrical signal to the TIA 202a, where the electrical signal is the first signal or the second signal.

With reference to FIG. 3 and FIG. 5, or with reference to FIG. 4 and FIG. 5, the TIA 202a is configured to receive a second signal and a third signal. The TIA 202a is further configured to: if determining that an error between a power of the second signal and a power of the third signal is less than a first preset threshold, obtain a first gain from the first storage module 202b by using the control apparatus 202c, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal. If determining that the error between the power of the second signal and the power of the third signal is less than the first preset threshold, after receiving the first signal, the TIA 202a may directly amplify, by using the control apparatus 202c, the first signal by using the first gain obtained from the first storage module 202b, and does not need to use the first signal to determine the first gain. Therefore, time required for determining the gain by the receive end apparatus 202 can be shortened, and the receive end apparatus 202 can quickly output a stable signal. That is, in this solution, duration from receiving a signal to outputting a stable signal by the receive end apparatus 202 may be shortened.

For example, the first preset threshold may be 1 dB or 0.5 dB.

In this embodiment of this application, a structure of the first transmit end apparatus 201a and the second transmit end apparatus 201b in FIG. 3, or a structure of the transmit end apparatus 201 in FIG. 4 may be shown in FIG. 8. The transmit end apparatus includes a digital-to-analog converter (digital-to-analog converter, DAC) 801, a semiconductor optical amplifier (semiconductor optical amplifier, SOA) 802, and a third storage module 803. The DAC 801 is configured to convert a digital signal into an analog signal. The SOA 802 is configured to amplify a to-be-sent signal by using a specific gain and send the amplified signal to a channel. The third storage module 803 is configured to store a correspondence between a signal reception identity and a gain and a signal sending power of the SOA. The signal reception identity includes an identity of a receive end apparatus of a signal and/or an identity of a channel on which the signal passes. With reference to FIG. 3, the first transmit end apparatus 201a may adjust the gain and/or the signal sending power of the SOA, and the second transmit end apparatus 201b may adjust the gain and/or the signal sending power of the SOA, so that the error between the power of the second signal received by the receive end apparatus 202 from the first transmit end apparatus 201a and the power of the third signal received from the second transmit end apparatus 201b is less than the first preset threshold. With reference to FIG. 4, the transmit end apparatus 201 may adjust the gain and/or the signal sending power of the SOA, so that the error between the power of the second signal received by the receive end apparatus 202 from the transmit end apparatus 201 on the first channel and the power of the third signal received from the transmit end apparatus 201 on the second channel is less than the first preset threshold.

Optionally, the TIA 202a is further configured to: after receiving the second signal or the third signal, amplify the second signal or the third signal by using a second gain, where the second gain is a preset initial gain. The TIA 202a is further configured to determine the first gain based on strength of the amplified second signal or strength of the amplified third signal. In this solution, before receiving the first signal, the TIA 202a pre-determines the first gain by using the second signal or the third signal, where the error between the power of the second signal and the power of the third signal is less than the first preset threshold, and the second signal or the third signal and the first signal have the same signal transmit identity. Therefore, after subsequently receiving the first signal, the TIA 202a may directly amplify the first signal by using the first gain stored in the first storage module 202b.

Optionally, the control apparatus 202c is configured to receive the signal transmit identity of the first signal. The TIA 202a is further configured to determine, based on strength of the amplified first signal, a third gain corresponding to the signal transmit identity of the first signal. The first storage module 202b is further configured to store a correspondence between the signal transmit identity of the first signal and the third gain. In this solution, because a transmission condition, for example, a channel condition, may change with time, the TIA 202a determines the third gain by using the first signal, and the first storage module 202b stores the correspondence between the signal transmit identity of the first signal and the third gain, so that the gain stored in the first storage module 202b can better meet a current transmission condition.

With reference to FIG. 3 and FIG. 6, or with reference to FIG. 4 and FIG. 6, the TIA 202a is configured to receive a second signal and a third signal. The TIA 202a is further configured to: if determining that an error between a power of the second signal and a power of the third signal is less than a first preset threshold, obtain a first gain from the first storage module 202b by using the control apparatus 202c, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal. For related descriptions of the solution, refer to the foregoing embodiments in FIG. 3 and FIG. 5 or the foregoing embodiments in FIG. 4 and FIG. 5. Details are not described herein again.

Optionally, the TIA 202a is further configured to: after receiving the second signal or the third signal, amplify the second signal or the third signal by using a second gain, where the second gain is a preset initial gain. The TIA 202a is further configured to determine the first gain based on strength of the amplified second signal or strength of the amplified third signal. For related descriptions of the solution, refer to the foregoing embodiments in FIG. 3 and FIG. 5 or the foregoing embodiments in FIG. 4 and FIG. 5. Details are not described herein again.

Optionally, the control apparatus 202c is configured to receive the signal transmit identity of the first signal. The AGC 202d is configured to determine, based on strength of the amplified first signal, a third gain corresponding to the signal transmit identity of the first signal. The first storage module 202b is further configured to store a correspondence between the signal transmit identity of the first signal and the third gain. In this solution, because a transmission condition, for example, a channel condition, may change with time, the AGC 202d determines the third gain by using the first signal, and the first storage module 202b stores the correspondence between the signal transmit identity of the first signal and the third gain, so that the gain stored in the first storage module 202b can better meet a current transmission condition.

With reference to FIG. 3 and FIG. 7, or with reference to FIG. 4 and FIG. 7, the TIA 202a is configured to receive a second signal and a third signal. The TIA 202a is further configured to: if determining that an error between a power of the second signal and a power of the third signal is less than a first preset threshold, obtain a first gain from the first storage module 202b by using the control apparatus 202c, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal. For related descriptions of the solution, refer to the foregoing embodiments in FIG. 3 and FIG. 5 or the foregoing embodiments in FIG. 4 and FIG. 5. Details are not described herein again.

Optionally, the TIA 202a is further configured to: after receiving the second signal or the third signal, amplify the second signal or the third signal by using a second gain, where the second gain is a preset initial gain. The TIA 202a is further configured to determine the first gain based on strength of the amplified second signal or strength of the amplified third signal. For related descriptions of the solution, refer to the foregoing embodiments in FIG. 3 and FIG. 5 or the foregoing embodiments in FIG. 4 and FIG. 5. Details are not described herein again.

Optionally, the control apparatus 202c is configured to receive the signal transmit identity of the first signal. The AGC 202d is configured to determine, based on strength of the amplified first signal, a third gain corresponding to the signal transmit identity of the first signal. The second storage module 202e is configured to store a correspondence between the signal transmit identity of the first signal and the third gain. The processing module 202f is configured to read the correspondence between the signal transmit identity of the first signal and the third gain from the second storage module 202e, and write the correspondence between the signal transmit identity of the first signal and the third gain into the first storage module 202b. In this solution, the AGC 202d may determine the third gain by using the first signal, and write the correspondence between the signal transmit identity of the first signal and the third gain into the first storage module 202b by using the second storage module 202e and the processing module 202f, so that the gain stored in the first storage module 202b can better meet a current transmission condition.

With reference to FIG. 3 and FIG. 6, or with reference to FIG. 4 and FIG. 6, the TIA 202a is configured to receive a second signal and a third signal. The TIA 202a is further configured to: if determining that an error between a power of the second signal and a power of the third signal is less than a first preset threshold, obtain a first gain from the first storage module 202b by using the control apparatus 202c, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal. For related descriptions of the solution, refer to the foregoing embodiments in FIG. 3 and FIG. 5 or the foregoing embodiments in FIG. 4 and FIG. 5. Details are not described herein again.

Optionally, the TIA 202a is further configured to: after receiving the second signal or the third signal, amplify the second signal or the third signal by using a second gain, where the second gain is a preset initial gain. The AGC 202d is configured to determine the first gain based on strength of the amplified second signal or strength of the amplified third signal. In this solution, before receiving the first signal, the AGC 202d pre-determines the first gain by using the second signal or the third signal, where the error between the power of the second signal and the power of the third signal is less than the first preset threshold, and the second signal or the third signal and the first signal have the same signal transmit identity. Therefore, after subsequently receiving the first signal, the TIA 202a may directly amplify the first signal by using the first gain stored in the first storage module 202b.

In a possible implementation, the control apparatus 202c is configured to receive the signal transmit identity of the first signal. The AGC 202d is further configured to determine, based on strength of the amplified first signal, a third gain corresponding to the signal transmit identity of the first signal. The first storage module 202b is further configured to store a correspondence between the signal transmit identity of the first signal and the third gain. In this solution, because a transmission condition, for example, a channel condition, may change with time, the AGC 202d determines the third gain by using the first signal, and the first storage module 202b stores the correspondence between the signal transmit identity of the first signal and the third gain, so that the gain stored in the first storage module 202b can better meet a current transmission condition.

In another possible implementation, the control apparatus 202c is configured to receive the signal transmit identity of the first signal. The TIA 202a is further configured to determine, based on strength of the amplified first signal, a third gain corresponding to the signal transmit identity of the first signal. The first storage module 202b is further configured to store a correspondence between the signal transmit identity of the first signal and the third gain. In this solution, because a transmission condition, for example, a channel condition, may change with time, the TIA 202a determines the third gain by using the first signal, and the first storage module 202b stores the correspondence between the signal transmit identity of the first signal and the third gain, so that the gain stored in the first storage module 202b can better meet a current transmission condition.

With reference to FIG. 3 and FIG. 7, or with reference to FIG. 4 and FIG. 7, the TIA 202a is configured to receive a second signal and a third signal. The TIA 202a is further configured to: if determining that an error between a power of the second signal and a power of the third signal is less than a first preset threshold, obtain a first gain from the first storage module 202b by using the control apparatus 202c, and after receiving a first signal, amplify the first signal by using the first gain. A signal transmit identity of the first signal is the same as a signal transmit identity of the second signal, or a signal transmit identity of the first signal is the same as a signal transmit identity of the third signal. The signal transmit identity indicates a transmit end apparatus of a signal or a channel for receiving the signal. For related descriptions of the solution, refer to the foregoing embodiments in FIG. 3 and FIG. 5 or the foregoing embodiments in FIG. 4 and FIG. 5. Details are not described herein again.

Optionally, the TIA 202a is further configured to: after receiving the second signal or the third signal, amplify the second signal or the third signal by using a second gain, where the second gain is a preset initial gain. The AGC 202d is further configured to determine the first gain based on strength of the amplified second signal or strength of the amplified third signal. The second storage module 202e is configured to store the first gain determined by the AGC 202d. The processing module 202f is configured to read the first gain from the second storage module 202e, and write the first gain into the first storage module 202b. In this solution, before receiving the first signal, the AGC 202d pre-determines the first gain by using the second signal or the third signal, where the error between the power of the second signal and the power of the third signal is less than the first preset threshold, the second signal or the third signal and the first signal have the same signal transmit identity, and the AGC 202d writes the first gain into the first storage module 202b by using the second storage module 202e and the processing module 202f. Therefore, after subsequently receiving the first signal, the TIA 202a may directly amplify the first signal by using the first gain stored in the first storage module 202b.

In a possible implementation, the control apparatus 202c is configured to receive the signal transmit identity of the first signal. The AGC 202d is further configured to determine, based on strength of the amplified first signal, a third gain corresponding to the signal transmit identity of the first signal. The second storage module 202e is further configured to store a correspondence between the signal transmit identity of the first signal and the third gain. The processing module 202f is configured to read the correspondence between the signal transmit identity of the first signal and the third gain from the second storage module 202e, and write the correspondence between the signal transmit identity of the first signal and the third gain into the first storage module 202b. In this solution, the AGC 202d may determine the third gain by using the first signal, and write the correspondence between the signal transmit identity of the first signal and the third gain into the first storage module 202b by using the second storage module 202e and the processing module 202f, so that the gain stored in the first storage module 202b can better meet a current transmission condition.

In another possible implementation, the control apparatus 202c is configured to receive the signal transmit identity of the first signal. The TIA 202a is further configured to determine, based on strength of the amplified first signal, a third gain corresponding to the signal transmit identity of the first signal. The first storage module 202b is further configured to store a correspondence between the signal transmit identity of the first signal and the third gain. In this solution, because a transmission condition, for example, a channel condition, may change with time, the TIA 202a determines the third gain by using the first signal, and the first storage module 202b stores the correspondence between the signal transmit identity of the first signal and the third gain, so that the gain stored in the first storage module 202b can better meet a current transmission condition.

Optionally, the receive end apparatus 202 shown in FIG. 5 to FIG. 7 may further include a photodiode. The photodiode is configured to receive an optical signal, convert the optical signal into an electrical signal, and send the electrical signal to the TIA 202a, where the electrical signal is the first signal, the second signal, or the third signal.

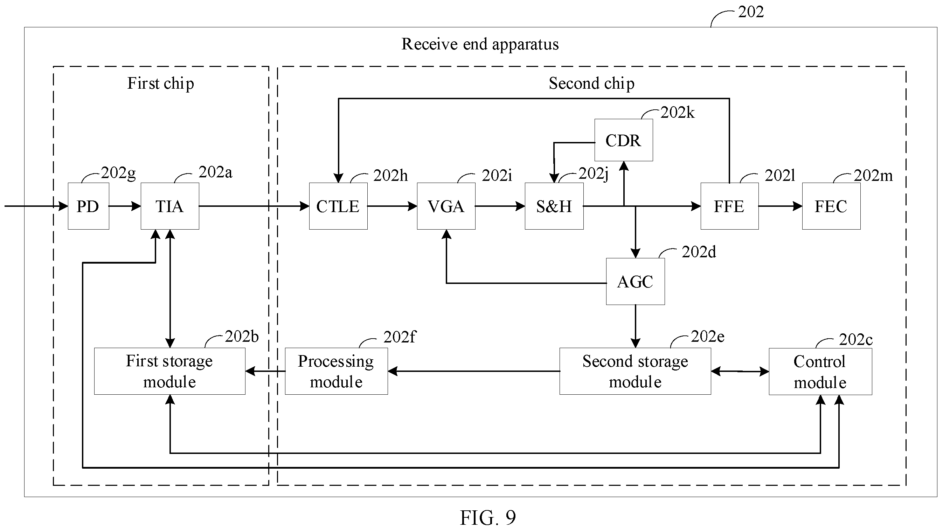

With reference to FIG. 7, FIG. 9 shows a specific example of a structure of the receive end apparatus 202 according to an embodiment of this application. For functions of the TIA 202a, the first storage module 202b, the AGC 202d, the second storage module 202e, and the processing module 202f, refer to the embodiment related to FIG. 7. For functions of a PD 202g, refer to the background. Details are not described herein again. The functions of other modules are as follows:

A continuous time linear equalizer (continuous time linear equalizer, CTLE) 202h is configured to compensate for a loss generated when a signal is communicated on a channel.

A variable gain amplifier (variable gain amplifier, VGA) 202i is configured to amplify or attenuate an analog signal.

A sampling and hold module (sampling and hold, S&H) 202j is configured to sample signals.

A clock data recovery (clock data recovery, CDR) 202k is configured to synchronize a clock of a receive end with a clock of a transmit end, so as to implement precise sampling of digital signals.

A feed forward equalizer (feed forward equalizer, FFE) 2021 is configured to equalize digital signals.

A forward error correction (forward error correction, FEC) 202m is configured to restore, based on digital signals and check information, data sent by the transmit end apparatus.

It should be noted that one or more of the foregoing modules or units may be implemented by using software, hardware, or a combination thereof. When any one of the foregoing modules or units is implemented by software, the software exists in a form of a computer program instruction, and is stored in the memory. The processor may be configured to execute the program instruction and implement the foregoing method procedure. The processor may be built into a SoC (system on chip) or an ASIC, or may be an independent semiconductor chip. In addition to a core configured to execute software instructions to perform an operation or processing, the processor may further include a necessary hardware accelerator, for example, a field programmable gate array (field programmable gate array, FPGA), a PLD (programmable logic device), or a logic circuit that implements a dedicated logic operation.

When the foregoing module or unit is implemented by hardware, the hardware may be any one or any combination of a CPU, a microprocessor, a digital signal processing (digital signal processing, DSP) chip, a microcontroller unit (microcontroller unit, MCU), an artificial intelligence processor, an ASIC, a SoC, an FPGA, a PLD, a dedicated digital circuit, a hardware accelerator, or a non-integrated discrete device. The hardware can run necessary software or perform the functions of the system described in the foregoing embodiment without depending on software.

Optionally, related functions of the receive end apparatus, the transmit end apparatus, the first transmit end apparatus, or the second transmit end apparatus in embodiments of this application may be implemented by one device, or may be jointly implemented by a plurality of devices, or may be implemented by one or more functional modules in one device. This is not specifically limited in embodiments of this application. It may be understood that the foregoing function may be a network element in a hardware device, a software function running on dedicated hardware, a combination of hardware and software, or a virtualized function instantiated on a platform (for example, a cloud platform).

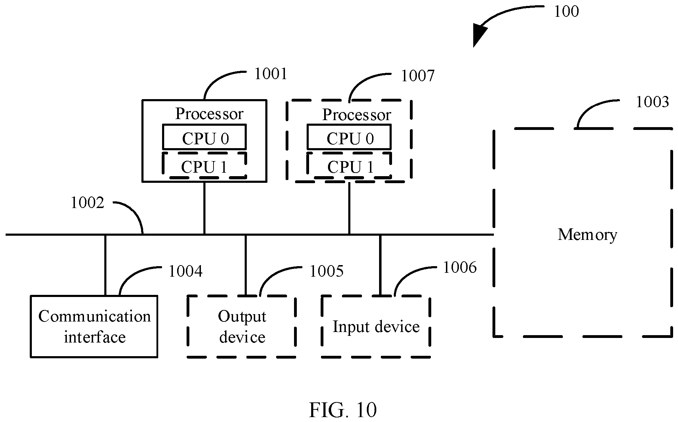

For example, related functions of the receive end apparatus, the transmit end apparatus, the first transmit end apparatus, or the second transmit end apparatus in embodiments of this application may be implemented by using a communication apparatus 100 in FIG. 10.

FIG. 10 is a diagram of a structure of the communication apparatus 100 according to an embodiment of this application. The communication apparatus 100 includes one or more processors 1001, a communication line 1002, and at least one communication interface (a communication interface 1004 and one processor 1001 are merely used as an example in FIG. 10 for description), and optionally may further include a memory 1003.

The processor 1001 may be a CPU, a microprocessor, an application-specific integrated circuit (application-specific integrated circuit, ASIC), or one or more integrated circuits configured to control program execution of the solutions of this application.

The communication line 1002 may include a path for connecting different components.

The communication interface 1004 may be a transceiver module, configured to communicate with another device or a communication network, for example, the Ethernet, a RAN, or a WLAN. For example, the transceiver module may be an apparatus, for example, a transceiver or a transceiver machine. Optionally, the communication interface 1004 may alternatively be a transceiver circuit located in the processor 1001, and is configured to implement signal input and signal output of the processor.

The memory 1003 may be an apparatus having a storage function, for example, may be a read-only memory (read-only memory, ROM) or another type of static storage device that can store static information and instructions, or a random access memory (random access memory, RAM) or another type of dynamic storage device that can store information and instructions; or may be an electrically erasable programmable read-only memory (electrically erasable programmable read-only memory, EEPROM), a compact disc read-only memory (compact disc read-only memory, CD-ROM) or another optical disk storage, an optical disc storage (including a compact disc, a laser disc, an optical disc, a digital versatile disc, a Blu-ray disc, or the like), a magnetic disk storage medium or another magnetic storage device, or any other medium that can be configured to carry or store expected program code having a form of an instruction or data structure and that can be accessed by a computer. However, this is not limited thereto. The memory may exist independently and is connected to the processor through the communication line 1002. The memory may alternatively be integrated with the processor.

The memory 1003 is configured to store computer-executable instructions for executing the solutions of this application, and the processor 1001 controls the execution. The processor 1001 is configured to execute the computer-executable instructions stored in the memory 1003, to implement the optical communication method provided in embodiments of this application.

Alternatively, in embodiments of this application, the processor 1001 may implement a processing-related function in the optical communication method provided in the following embodiment of this application, and the communication interface 1004 may be responsible for communicating with another device or communication network. This is not specifically limited in embodiments of this application.

The computer-executable instructions in embodiments of this application may also be referred to as application program code. This is not specifically limited in embodiments of this application.

During specific implementation, in an embodiment, the processor 1001 may include one or more CPUs, for example, a CPU 0 and a CPU 1 in FIG. 10.

During specific implementation, in an embodiment, the communication apparatus 100 may include a plurality of processors, for example, the processor 1001 and a processor 1007 in FIG. 10. Each of the processors may be a single-core (single-CPU) processor, or may be a multicore (multi-CPU) processor. The processor herein may be one or more devices, circuits, and/or processing cores configured to process data (for example, computer program instructions).

During specific implementation, in an embodiment, the communication apparatus 100 may further include an output device 1005 and an input device 1006. The output device 1005 communicates with the processor 1001, and may display information in a plurality of manners.

The communication apparatus 100 may be a general-purpose apparatus or a dedicated apparatus.

It may be understood that a structure shown in any one of FIG. 5 to FIG. 7 or shown in FIG. 9 does not constitute a specific limitation on the receive end apparatus 202. The apparatus may have more or fewer components than those shown in any one of FIG. 5 to FIG. 7 or shown in FIG. 9, may combine two or more components, or may have different component configurations.

In a simple embodiment, a person skilled in the art may figure out that the receive end apparatus 202 may be in a form of the communication apparatus 100 shown in FIG. 10.

For example, a function/implementation process of the TIA 202a or the control apparatus 202c in FIG. 5 may be implemented by invoking, by the processor 1001 in the communication apparatus 100 shown in FIG. 10, the computer-executable instructions stored in the memory 1003. The first storage module 202b in FIG. 5 may be implemented by using the memory 1003 in FIG. 10.

For example, a function/implementation process of the TIA 202a, the control apparatus 202c, or the AGC 202d in FIG. 6 may be implemented by invoking, by the processor 1001 in the communication apparatus 100 shown in FIG. 10, the computer-executable instructions stored in the memory 1003. The first storage module 202b in FIG. 6 may be implemented by using the memory 1003 in FIG. 10.

For example, a function/implementation process of the TIA 202a, the control apparatus 202c, the AGC 202d, or the processing module 202f in FIG. 7 may be implemented by invoking, by the processor 1001 in the communication apparatus 100 shown in FIG. 10, the computer-executable instructions stored in the memory 1003. The first storage module 202b or the second storage module 202e in FIG. 7 may be implemented by using the memory 1003 in FIG. 10.

For example, the PD 202g in FIG. 9 is implemented by using the communication interface 1004 in FIG. 10. A function/implementation process of the TIA 202a, the AGC 202d, the processing module 202f, the CTLE 202h, the VGA 202i, the S&H 202j, the CDR 202k, the FFE 2021, or the FEC 202m in FIG. 9 may be implemented by invoking, by the processor 1001 in the communication apparatus 100 shown in FIG. 10, the computer-executable instructions stored in the memory 1003. The first storage module 202b or the second storage module 202e in FIG. 9 may be implemented by using the memory 1003 in FIG. 10.

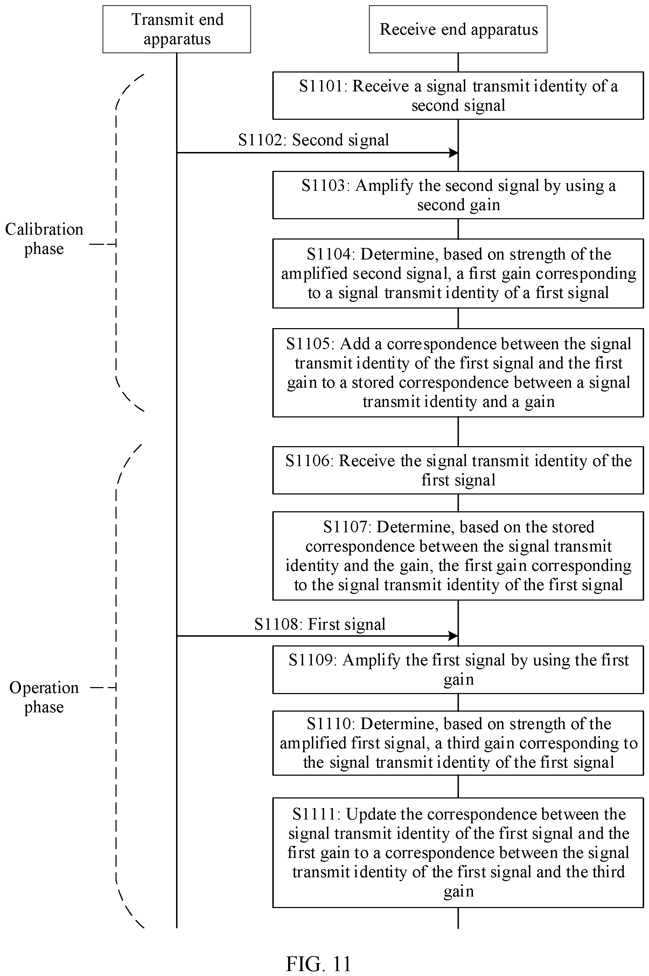

FIG. 11 shows an example of an optical communication method according to this application. The example may include the following steps.

Step S1101: A receive end apparatus receives a signal transmit identity of a second signal, where the signal transmit identity indicates a transmit end apparatus of a signal or a channel for receiving the signal.

Step S1102: A transmit end apparatus sends the second signal to the receive end apparatus, where the signal transmit identity of the second signal is the same as a signal transmit identity of a first signal.

Step S1103: The receive end apparatus amplifies the second signal by using a second gain, where the second gain is a preset initial gain.

Step S1104: The receive end apparatus determines, based on strength of the amplified second signal, a first gain corresponding to the signal transmit identity of the first signal.

Step S1105: The receive end apparatus adds a correspondence between the signal transmit identity of the first signal and the first gain to a stored correspondence between a signal transmit identity and a gain.

It should be noted that step S1101 to step S1105 may be performed, for example, in a calibration phase.

Step S1106: The receive end apparatus receives the signal transmit identity of the first signal.

Step S1107: The receive end apparatus determines, based on the stored correspondence between the signal transmit identity and the gain, the first gain corresponding to the signal transmit identity of the first signal.

Step S1108: The transmit end apparatus sends the first signal to the receive end apparatus. Correspondingly, the receive end apparatus receives the first signal.

Step S1109: The receive end apparatus amplifies the first signal by using the first gain.

Step S1110: The receive end apparatus determines, based on strength of the amplified first signal, a third gain corresponding to the signal transmit identity of the first signal.

Step S1111: The receive end apparatus updates the correspondence between the signal transmit identity of the first signal and the first gain to a correspondence between the signal transmit identity of the first signal and the third gain.

It should be noted that step S1106 to step 51111 may be performed, for example, in an operation phase.

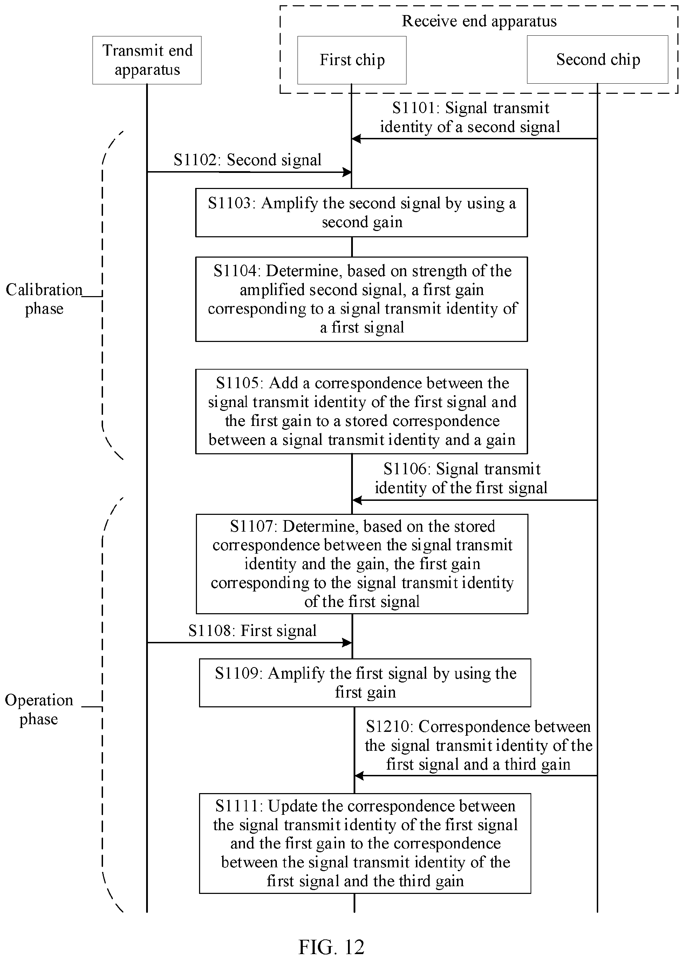

FIG. 12 shows an example of an optical communication method according to this application. In this example, a first chip in a receive end apparatus is equivalent to the receive end apparatus in step S1101 to step S1109 and step S1111. For detailed descriptions, refer to the embodiment shown in FIG. 11. Details are not described herein again. Different from the embodiment shown in FIG. 11, the method includes the following steps.

Step S1210: A second chip writes a correspondence between the signal transmit identity of the first signal and a third gain into the first chip, where the third gain is determined by an AGC based on strength of the amplified first signal.

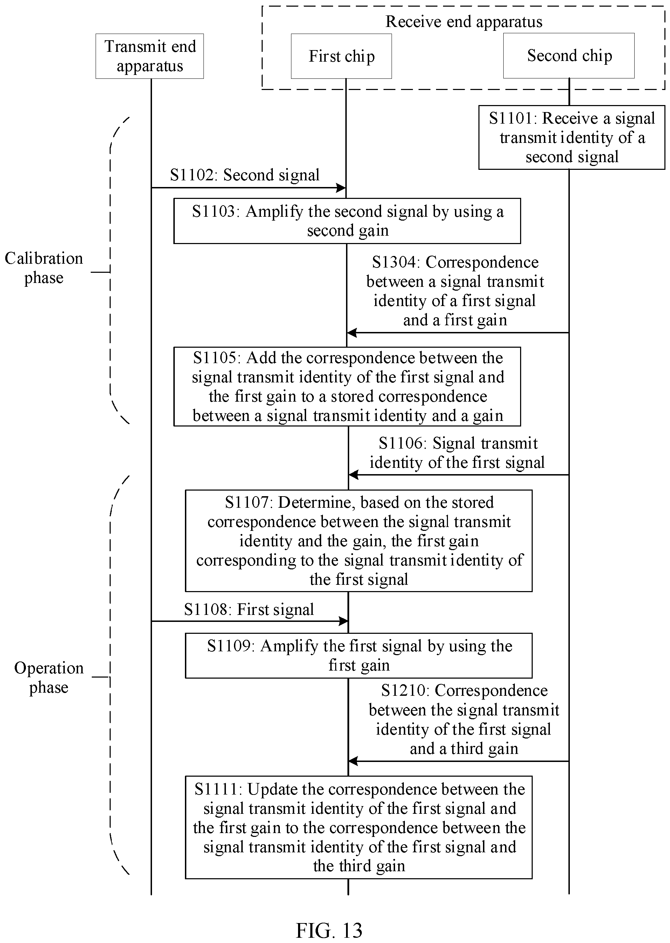

FIG. 13 shows an example of an optical communication method according to this application. In this example, a second chip in a receive end apparatus is equivalent to the receive end apparatus in step S1101, and a first chip in the receive end apparatus is equivalent to the receive end apparatus in step S1102, step S1103, step S1105 to step S1109, and step S1111. The example further includes step S1210. For detailed descriptions, refer to the embodiments shown in FIG. 11 and FIG. 12. Details are not described herein again. Different from the embodiment shown in FIG. 12, the method includes the following steps.

Step S1304: The second chip writes a correspondence between the signal transmit identity of the first signal and a first gain into the first chip, where the first gain is determined by an AGC based on strength of the amplified second signal.

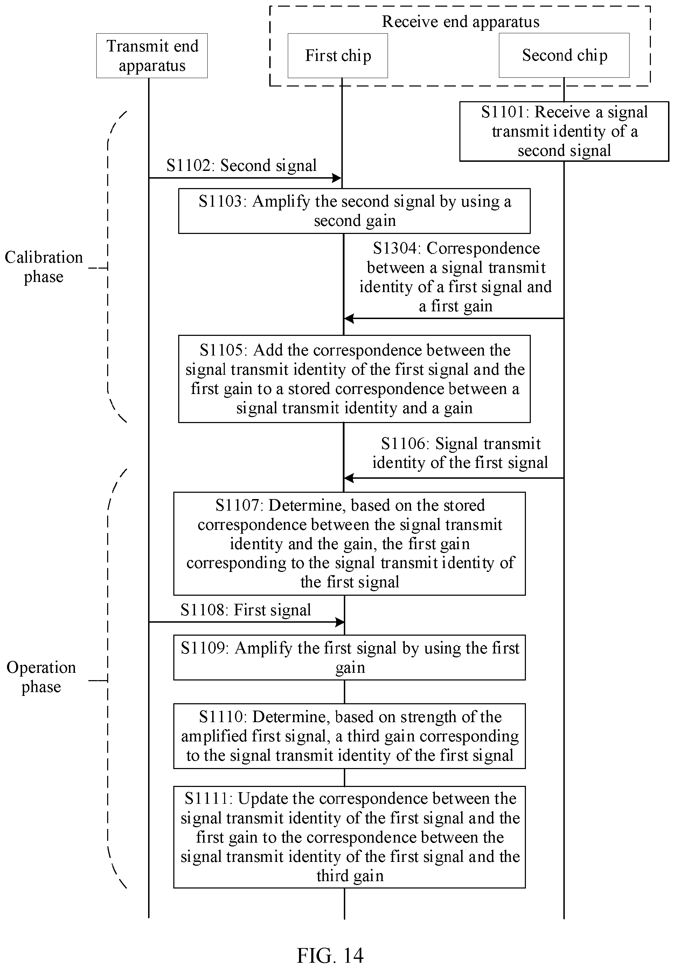

FIG. 14 shows an example of an optical communication method according to this application. In this example, a second chip in a receive end apparatus is equivalent to the receive end apparatus in step S1101, and a first chip in the receive end apparatus is equivalent to the receive end apparatus in step S1102, step S1103, and step S1105 to step S1111. The example further includes step S1304. For detailed descriptions, refer to the embodiments shown in FIG. 11 and FIG. 13. Details are not described herein again.

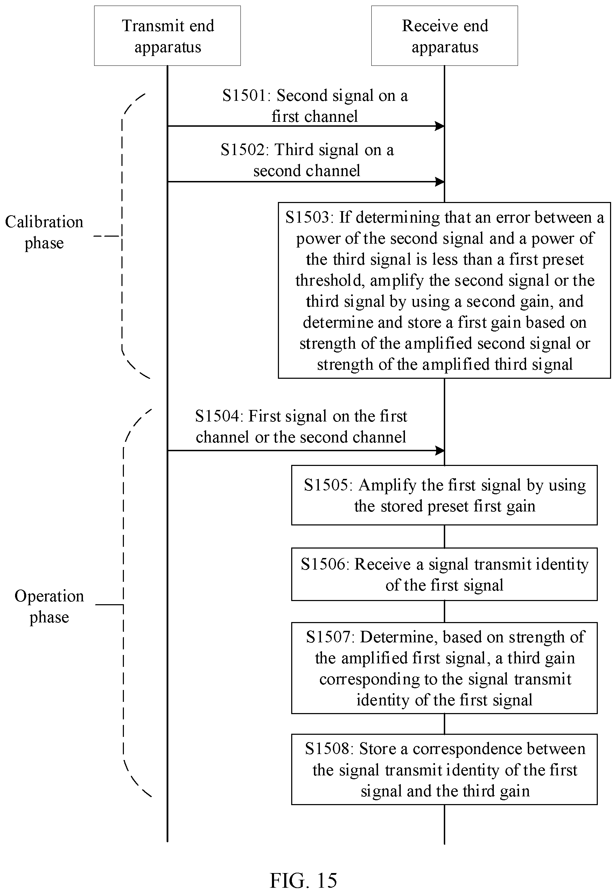

FIG. 15 shows an example of another optical communication method according to this application. The example may include the following steps.

Step S1501: A transmit end apparatus sends a second signal to a receive end apparatus on a first channel. Correspondingly, the receive end apparatus receives the second signal from the transmit end apparatus on the first channel.

Step S1502: The transmit end apparatus sends a third signal to the receive end apparatus on a second channel. Correspondingly, the receive end apparatus receives the third signal from the transmit end apparatus on the second channel.

In this embodiment of this application, step S1501 and step S1502 may also be replaced with the following steps: A first transmit end apparatus sends a second signal to a receive end apparatus. Correspondingly, the receive end apparatus receives the second signal from the first transmit end apparatus. A second transmit end apparatus sends a third signal to the receive end apparatus. Correspondingly, the receive end apparatus receives the third signal from the second transmit end apparatus.

Step S1503: If determining that an error between a power of the second signal and a power of the third signal is less than a first preset threshold, the receive end apparatus amplifies the second signal or the third signal by using a second gain, and determines a first gain based on strength of the amplified second signal or strength of the amplified third signal, where the second gain is a preset initial gain.

It should be noted that step S1501 to step S1503 may be performed, for example, in a calibration phase.

Step S1504: The transmit end apparatus sends a first signal to the receive end apparatus on the first channel or the second channel, where a signal transmit identity of the first signal is the same as a signal transmit identity of the second signal, or a signal transmit identity of the first signal is the same as a signal transmit identity of the third signal; and the signal transmit identity indicates a transmit end apparatus of a signal or a channel for receiving the signal. Correspondingly, the receive end apparatus receives the first signal from the transmit end apparatus on the first channel or the second channel.

In this embodiment of this application, step S1501 and step S1502 may also be replaced with the following steps: A first transmit end apparatus or a second transmit end apparatus sends a first signal to a receive end apparatus. Correspondingly, the receive end apparatus receives the first signal from the first transmit end apparatus or the second transmit end apparatus.

Step S1505: The receive end apparatus amplifies the first signal by using the stored preset first gain.

Step S1506: The receive end apparatus receives the signal transmit identity of the first signal.

Step S1507: The receive end apparatus determines, based on strength of the amplified first signal, a third gain corresponding to the signal transmit identity of the first signal.

Step S1508: The receive end apparatus stores a correspondence between the signal transmit identity of the first signal and the third gain.

It should be noted that step S1504 to step S1508 may be performed, for example, in an operation phase.

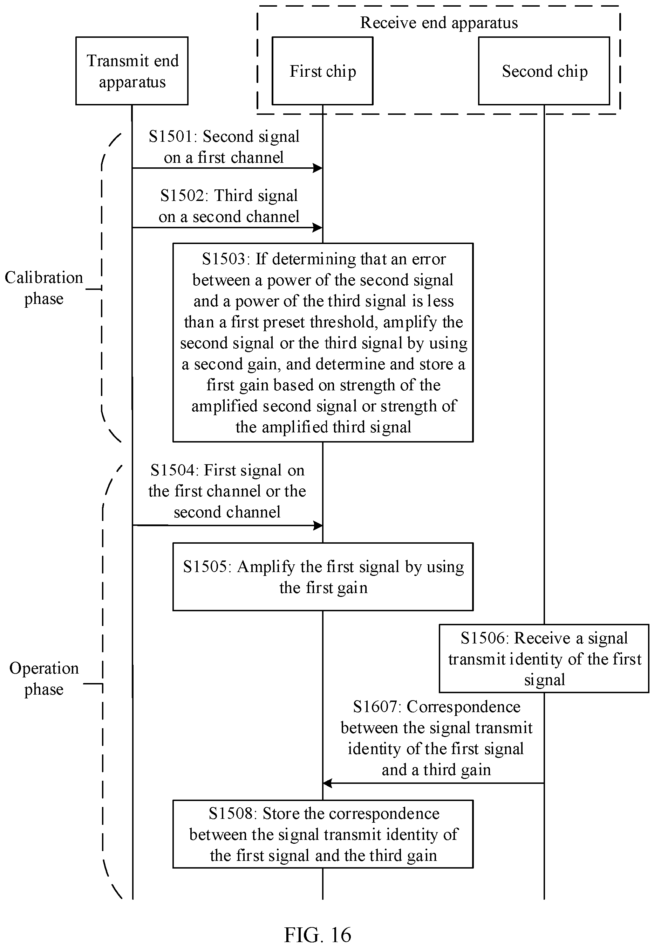

FIG. 16 shows an example of another optical communication method according to this application. In this example, a first chip in a receive end apparatus is equivalent to the receive end apparatus in step S1501 to step S1505 and step S1508. A second chip in the receive end apparatus is equivalent to the receive end apparatus in step S1506. For detailed descriptions, refer to the embodiment shown in FIG. 15. Details are not described herein again. Different from the embodiment shown in FIG. 15, the method includes the following steps.

Step S1607: The second chip writes a correspondence between the signal transmit identity of the first signal and a third gain into the first chip, where the third gain is determined by an AGC based on strength of the amplified first signal.

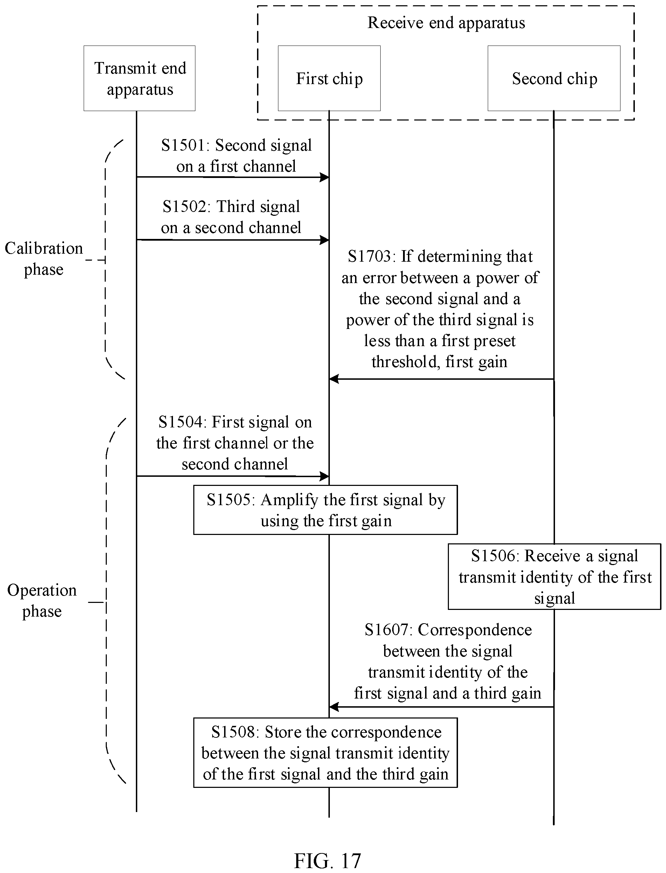

FIG. 17 shows an example of another optical communication method according to this application. In this example, a first chip in a receive end apparatus is equivalent to the receive end apparatus in step S1501, step S1502, step S1504, step S1505, and step S1508, and a second chip in the receive end apparatus is equivalent to the receive end apparatus in step S1506. The example further includes step S1607. For detailed descriptions, refer to the embodiments shown in FIG. 15 and FIG. 16. Details are not described herein again. Different from the embodiment shown in FIG. 16, the method includes the following steps.

Step S1703 : The second chip writes a first gain into the first chip, where if determining that an error between a power of the second signal and a power of the third signal is less than a first preset threshold, an AGC determines the first gain based on strength of the amplified second signal or strength of the amplified third signal.

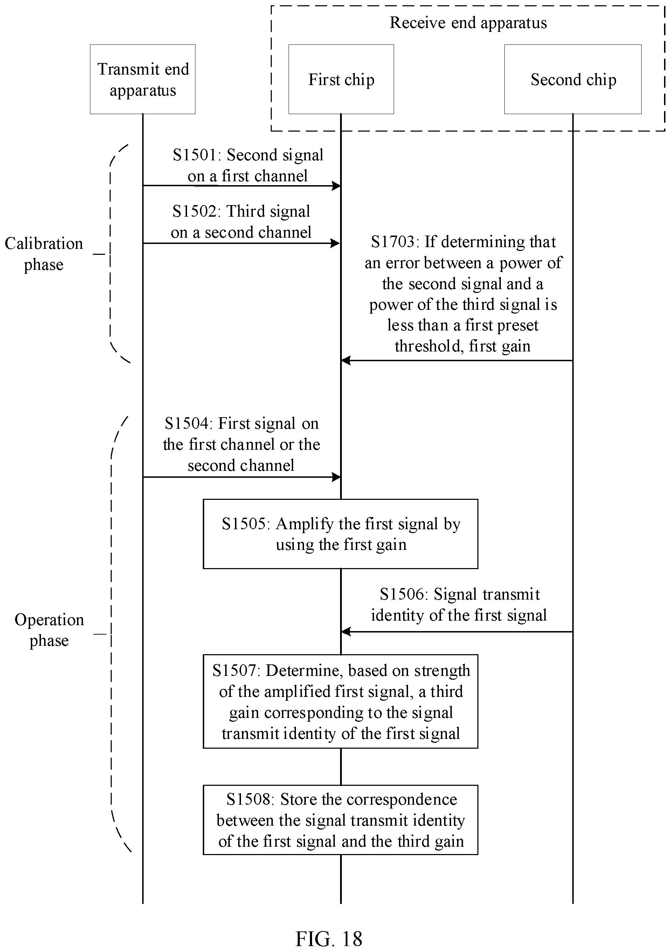

FIG. 18 shows an example of another optical communication method according to this application. In this example, a first chip in a receive end apparatus is equivalent to the receive end apparatus in step S1501, step S1502, and step S1504 to step S1508. The example further includes step S1703. For detailed descriptions, refer to the embodiments shown in FIG. 15 and FIG. 17. Details are not described herein again.

Related content in the foregoing method embodiments may be cited in function descriptions of the corresponding functional modules in the apparatus embodiments. Details are not described herein again.

Optionally, an embodiment of this application further provides a chip system, including: at least one processor and an interface. The at least one processor is coupled to a memory through an interface. When the at least one processor executes a computer program or instructions in the memory, the method in any one of FIG. 11 to FIG. 18 is performed. In a possible implementation, the chip system further includes the memory. Optionally, the chip system may include a chip, or may include a chip and another discrete component. This is not specifically limited in embodiments of this application.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from one computer-readable storage medium to another computer-readable storage medium. For example, the computer instructions may be transmitted from one website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any available medium accessible by a computer, or include one or more data storage devices such as a server and a data center that can be integrated with a medium. The available medium may be a magnetic medium (for example, a floppy disk, a hard disk, or a magnetic tape), an optical medium (for example, a DVD), a semiconductor medium (for example, a solid state disk (solid state disk, SSD)), or the like.

Although this application is described herein with reference to the embodiments, in a process of implementing this application that claims protection, a person skilled in the art may understand and implement other variations of the disclosed embodiments by viewing the accompanying drawings, disclosed content, and appended claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce a better effect.

Although this application is described with reference to specific features and embodiments thereof, it is clear that various modifications and combinations may be made to them without departing from the spirit and scope of this application. Correspondingly, this specification and accompanying drawings are merely example description of this application defined by the accompanying claims, and are considered as any of or all modifications, variations, combinations, or equivalents that cover the scope of this application. It is clear that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A receive end apparatus, wherein the receive end apparatus comprises a trans-impedance amplifier TIA, a control apparatus, and a first storage module;
the control apparatus is configured to receive a signal transmit identity of a first signal, and determine, based on a correspondence that is between a signal transmit identity and a gain and that is stored in the first storage module, a first gain corresponding to the signal transmit identity of the first signal, wherein the signal transmit identity indicates a transmit end apparatus of a signal or a channel for receiving the signal; and
the TIA is configured to obtain the first gain from the control apparatus, and after receiving the first signal, amplify the first signal by using the first gain.

2. The receive end apparatus according to claim 1, wherein
the control apparatus is further configured to receive a signal transmit identity of a second signal, wherein the signal transmit identity of the second signal is the same as the signal transmit identity of the first signal;
the TIA is further configured to: before receiving the first signal, receive the second signal, and amplify the second signal by using a second gain, wherein the second gain is a preset initial gain;
the TIA is further configured to determine, based on strength of the amplified second signal, the first gain corresponding to the signal transmit identity of the first signal; and
the first storage module is configured to add a correspondence between the signal transmit identity of the first signal and the first gain to the correspondence between the signal transmit identity and the gain.

3. The receive end apparatus according to claim 2, wherein
the TIA is further configured to determine, based on strength of the amplified first signal, a third gain corresponding to the signal transmit identity of the first signal; and
the first storage module is further configured to update the correspondence between the signal transmit identity of the first signal and the first gain to a correspondence between the signal transmit identity of the first signal and the third gain.

4. The receive end apparatus according to claim 2, wherein the receive end apparatus further comprises an automatic gain control AGC;
the AGC is configured to determine, based on strength of the amplified first signal, a third gain corresponding to the signal transmit identity of the first signal; and
the first storage module is further configured to update the correspondence between the signal transmit identity of the first signal and the first gain to a correspondence between the signal transmit identity of the first signal and the third gain.

5. The receive end apparatus according to claim 2, wherein the receive end apparatus further comprises an AGC, a processing module, and a second storage module coupled to the AGC;
the AGC is configured to determine, based on strength of the amplified first signal, a third gain corresponding to the signal transmit identity of the first signal;
the second storage module is configured to store a correspondence between the signal transmit identity of the first signal and the third gain; and
the processing module is configured to read the correspondence between the signal transmit identity of the first signal and the third gain from the second storage module, and update the correspondence between the signal transmit identity of the first signal and the first gain in the first storage module to the correspondence between the signal transmit identity of the first signal and the third gain.

6. The receive end apparatus according to claim 1, wherein the receive end apparatus further comprises an AGC;
the control apparatus is further configured to receive a signal transmit identity of a second signal, wherein the signal transmit identity of the second signal is the same as the signal transmit identity of the first signal;
the TIA is further configured to: before receiving the first signal, receive the second signal, and amplify the second signal by using a second gain, wherein the second gain is a preset initial gain;
the AGC is configured to determine, based on strength of the amplified second signal, the first gain corresponding to the signal transmit identity of the first signal; and
the first storage module is configured to add a correspondence between the signal transmit identity of the first signal and the first gain to the correspondence between the signal transmit identity and the gain.

7. The receive end apparatus according to claim 6, wherein
the AGC is further configured to determine, based on strength of the amplified first signal, a third gain corresponding to the signal transmit identity of the first signal; and
the first storage module is further configured to update the correspondence between the signal transmit identity of the first signal and the first gain to a correspondence between the signal transmit identity of the first signal and the third gain.

8. The receive end apparatus according to claim 6, wherein
the TIA is further configured to determine, based on strength of the amplified first signal, a third gain corresponding to the signal transmit identity of the first signal; and
the first storage module is further configured to update the correspondence between the signal transmit identity of the first signal and the first gain to a correspondence between the signal transmit identity of the first signal and the third gain.

9. The receive end apparatus according to claim 1, wherein the receive end apparatus further comprises an AGC, a processing module, and a second storage module coupled to the AGC;
the control apparatus is further configured to receive a signal transmit identity of a second signal, wherein the signal transmit identity of the second signal is the same as the signal transmit identity of the first signal;
the TIA is further configured to: before receiving the first signal, receive the second signal, and amplify the second signal by using a second gain, wherein the second gain is a preset initial gain;
the AGC is configured to determine, based on strength of the amplified second signal, the first gain corresponding to the signal transmit identity of the first signal;
the second storage module is configured to store a correspondence between the signal transmit identity of the first signal and the first gain; and
the processing module is configured to read the correspondence between the signal transmit identity of the first signal and the first gain from the second storage module, and add the correspondence between the signal transmit identity of the first signal and the first gain to the correspondence that is between the signal transmit identity and the gain and that is stored in the first storage module.

10. The receive end apparatus according to claim 9, wherein
the AGC is further configured to determine, based on strength of the amplified first signal, a third gain corresponding to the signal transmit identity of the first signal;
the second storage module is configured to store a correspondence between the signal transmit identity of the first signal and the third gain; and
the processing module is configured to read the correspondence between the signal transmit identity of the first signal and the third gain from the second storage module, and update the correspondence between the signal transmit identity of the first signal and the first gain in the first storage module to the correspondence between the signal transmit identity of the first signal and the third gain.

11. The receive end apparatus according to claim 9, wherein
the TIA is further configured to determine, based on strength of the amplified first signal, a third gain corresponding to the signal transmit identity of the first signal; and
the first storage module is further configured to update the correspondence between the signal transmit identity of the first signal and the first gain to a correspondence between the signal transmit identity of the first signal and the third gain.

12. The receive end apparatus according to any one of claims 1 to 11, wherein the receive end apparatus further comprises a photodiode; and
the photodiode is configured to receive an optical signal, convert the optical signal into an electrical signal, and send the electrical signal to the TIA, wherein the electrical signal is the first signal or the second signal.

13. The receive end apparatus according to claim 4, 6, 7, or 8, wherein the control apparatus, the TIA, the first storage module, and the AGC are located on a first chip.

14. The receive end apparatus according to claim 5, 9, 10, or 11, wherein the TIA and the first storage module are located on a first chip, and the control apparatus, the AGC, the processing module, and the second storage module are located on a second chip.

15. A receive end apparatus, wherein the receive end apparatus comprises a trans-impedance amplifier TIA, a control apparatus, and a first storage module;
the TIA is configured to receive a second signal and a third signal; and
the TIA is further configured to: if determining that an error between a power of the second signal and a power of the third signal is less than a first preset threshold, obtain a first gain from the first storage module by using the control apparatus, and after receiving a first signal, amplify the first signal by using the first gain, wherein
a signal transmit identity of the first signal is the same as a signal transmit identity of the second signal, or a signal transmit identity of the first signal is the same as a signal transmit identity of the third signal; and the signal transmit identity indicates a transmit end apparatus of a signal or a channel for receiving the signal.

16. The receive end apparatus according to claim 15, wherein
the TIA is further configured to: after receiving the second signal or the third signal, amplify the second signal or the third signal by using a second gain, wherein the second gain is a preset initial gain; and
the TIA is further configured to determine the first gain based on strength of the amplified second signal or strength of the amplified third signal.

17. The receive end apparatus according to claim 16, wherein
the control apparatus is configured to receive the signal transmit identity of the first signal; the TIA is further configured to determine, based on strength of the amplified first signal, a third gain corresponding to the signal transmit identity of the first signal; and
the first storage module is further configured to store a correspondence between the signal transmit identity of the first signal and the third gain.

18. The receive end apparatus according to claim 16, wherein the receive end apparatus further comprises an automatic gain control AGC;
the control apparatus is configured to receive the signal transmit identity of the first signal; the AGC is configured to determine, based on strength of the amplified first signal, a third gain corresponding to the signal transmit identity of the first signal; and
the first storage module is further configured to store a correspondence between the signal transmit identity of the first signal and the third gain.

19. The receive end apparatus according to claim 16, wherein the receive end apparatus further comprises an AGC, a processing module, and a second storage module coupled to the AGC;
the control apparatus is configured to receive the signal transmit identity of the first signal;
the AGC is configured to determine, based on strength of the amplified first signal, a third gain corresponding to the signal transmit identity of the first signal;
the second storage module is configured to store a correspondence between the signal transmit identity of the first signal and the third gain; and
the processing module is configured to read the correspondence between the signal transmit identity of the first signal and the third gain from the second storage module, and write the correspondence between the signal transmit identity of the first signal and the third gain into the first storage module.

20. The receive end apparatus according to claim 15, wherein the receive end apparatus further comprises an AGC;
the TIA is further configured to: after receiving the second signal or the third signal, amplify the second signal or the third signal by using a second gain, wherein the second gain is a preset initial gain; and
the AGC is configured to determine the first gain based on strength of the amplified second signal or strength of the amplified third signal.

21. The receive end apparatus according to claim 20, wherein
the control apparatus is configured to receive the signal transmit identity of the first signal; the AGC is further configured to determine, based on strength of the amplified first signal, a third gain corresponding to the signal transmit identity of the first signal; and
the first storage module is further configured to store a correspondence between the signal transmit identity of the first signal and the third gain.

22. The receive end apparatus according to claim 20, wherein
the control apparatus is configured to receive the signal transmit identity of the first signal; the TIA is further configured to determine, based on strength of the amplified first signal, a third gain corresponding to the signal transmit identity of the first signal; and
the first storage module is further configured to store a correspondence between the signal transmit identity of the first signal and the third gain.

23. The receive end apparatus according to claim 15, wherein the receive end apparatus further comprises an AGC, a processing module, and a second storage module coupled to the AGC;
the TIA is further configured to: after receiving the second signal or the third signal, amplify the second signal or the third signal by using a second gain, wherein the second gain is a preset initial gain;
the AGC is further configured to determine the first gain based on strength of the amplified second signal or strength of the amplified third signal;
the second storage module is configured to store the first gain determined by the AGC; and the processing module is configured to read the first gain from the second storage module, and write the first gain into the first storage module.

24. The receive end apparatus according to claim 23, wherein
the control apparatus is configured to receive the signal transmit identity of the first signal; the AGC is further configured to determine, based on strength of the amplified first signal, a third gain corresponding to the signal transmit identity of the first signal;
the second storage module is further configured to store a correspondence between the signal transmit identity of the first signal and the third gain; and
the processing module is configured to read the correspondence between the signal transmit identity of the first signal and the third gain from the second storage module, and write the correspondence between the signal transmit identity of the first signal and the third gain into the first storage module.

25. The receive end apparatus according to claim 23, wherein
the control apparatus is configured to receive the signal transmit identity of the first signal; the TIA is further configured to determine, based on strength of the amplified first signal, a third gain corresponding to the signal transmit identity of the first signal; and
the first storage module is further configured to store a correspondence between the signal transmit identity of the first signal and the third gain.

26. The receive end apparatus according to any one of claims 15 to 25, wherein the receive end apparatus further comprises a photodiode; and
the photodiode is configured to receive an optical signal, convert the optical signal into an electrical signal, and send the electrical signal to the TIA, wherein the electrical signal is the first signal, the second signal, or the third signal.

27. The receive end apparatus according to claim 17, 19, 20, or 21, wherein the control apparatus, the TIA, the first storage module, and the AGC are located on a first chip.

28. The receive end apparatus according to claim 18, 22, 23, or 24, wherein the TIA and the first storage module are located on a first chip, and the control apparatus, the AGC, the processing module, and the second storage module are located on a second chip.

29. An optical communication method, wherein the method is applied to a receive end apparatus, and the method comprises:
receiving a signal transmit identity of a first signal, and determining, based on a correspondence that is between a signal transmit identity and a gain and that is stored in a first storage module, a first gain corresponding to the signal transmit identity of the first signal, wherein the signal transmit identity indicates a transmit end apparatus of a signal or a channel for receiving the signal; and
obtaining the first gain from a control apparatus, and after receiving the first signal, amplifying the first signal by using the first gain.

30. An optical communication method, wherein the method is applied to a receive end apparatus, and the method comprises:
receiving a second signal and a third signal; and
if determining that an error between a power of the second signal and a power of the third signal is less than a first preset threshold, obtaining a first gain from a first storage module by using a control apparatus, and after receiving a first signal, amplifying the first signal by using the first gain, wherein
a signal transmit identity of the first signal is the same as a signal transmit identity of the second signal, or a signal transmit identity of the first signal is the same as a signal transmit identity of the third signal; and the signal transmit identity indicates a transmit end apparatus of a signal or a channel for receiving the signal.
